# EUROPEAN PATENT APPLICATION

(11) **EP 4 770 407 A1**
(43) Date of publication of application: **01.07.2026**
(21) Application number: 25225967.6
(22) Date of filing: 19.12.2025
(51) Int. Cl.: H10W 40/22, H10W 40/25, H10W 40/77

(54) **CONNECTION ELEMENTS FOR DOUBLE-SIDED COOLING (DSC) DEVICE OR POWER MODULE AND METHODS OF MANUFACTURING THE SAME**

(30) Priority: 27.12.2024 US 202419003703
(71) Applicant: STMicroelectronics International N.V., 1228 Plan-les-Ouates, Geneva (CH)
(72) Inventor: PAUL, Indrajit, D-88677 Markdorf (DE); YOO, Inpil, D-82008 Unterhaching (DE); DIVAY, Valentin, D-85622 Feldkirchen (DE)
(74) Representative: Buzzi, Notaro & Antonielli d'Oulx S.p.A.

(57) **Abstract**

A double-sided cooling (DSC) semiconductor package (213) is summarized as including a first assembly having a plurality of pillars (202) that extend outward from a first heat sink or dissipation structure (102) and at least one die (204) that is pre-coupled to the first heat sink or dissipation structure (102). A second assembly includes a plurality of flanges (210, 240) that are pre-welded or pre-coupled to a second heat sink or dissipation structure (104). The first assembly and second assembly are pre-formed before being coupled together. After the first assembly and the second assembly have been formed, the first assembly is coupled to the second assembly. After the pre-formed stacked semiconductor assembly has been formed, a molding compound (215) is applied to form the first embodiment of the double-sided cooling (DSC) semiconductor package or device.

## Description

### BACKGROUND

### Technical Field

The present disclosure is directed to one or more embodiments of semiconductor packages or devices including double-sided cooling (DSC) structures, and a method of manufacturing the same.

### Description of the Related Art

The semiconductor industry has been showing considerable interest in techniques and structures to reduce or prevent effects generated by thermo-mechanical stresses. For example, when a heat sink, slug, or spreader is present on a die of a semiconductor package or device and there is an increase in temperature in an environment in which the package is present, the heat sink, slug, or spreader may expand when dissipating the thermal energy within the semiconductor package generated by the increase in temperature. To further increase or dissipate this thermal energy due to the increase in temperature within the semiconductor package or device, the semiconductor package or device includes a first heat sink structure at a first side and a second heat sink structure at a second side opposite the first side. Generally, a number of spacer structures are provided along at least one of the first heat sink structure or the second heat sink structure such that the first and second heat sink structures are spaced apart from each other leaving ample space for the die between the first and second heat sink structures. These types of semiconductor packages or devices are generally referred to as double-sided cooling (DSC) semiconductor packages or devices. As these double-sided cooling (DSC) packages are exposed to increases in temperature, CTE (coefficient of thermal expansion) mismatch between the first heat sink structure, the second heat sink structure, and the die, as well as electrical connections or pathways within the semiconductor package or device can result in propagation of mechanical defects within the double-sided cooling (DSC) semiconductor packages or devices.

Generally, manufacturing or producing these double-sided cooling (DSC) semiconductor packages or devices is costly in order to stack and couple together the first heat sink structure, the second heat sink structure, and the die, as well as forming respective electrical connections or pathways within the semiconductor device or package. For example, the materials in manufacturing these double-sided cooling (DSC) semiconductor packages or devices are expensive and can also be susceptible to mechanical defects due to CTE mismatches.

### BRIEF SUMMARY

The present disclosure is directed to one or more embodiments of double-sided cooling (DSC) semiconductor packages or devices.

For example, at least one embodiment of a double-sided cooling (DSC) semiconductor package is summarized as including a first assembly having a plurality of pillars that extend outward from a first heat sink or dissipation structure and at least one die that is pre-coupled to the first heat sink or dissipation structure. In this first embodiment, a second assembly includes a plurality of flanges that are pre-welded or pre-coupled to a second heat sink or dissipation structure. The first assembly and second assembly are pre-formed before being coupled together. After the first assembly and the second assembly have been formed, the first assembly is coupled to the second assembly. In coupling the first assembly to the second assembly, the plurality of flanges are coupled to respective contacts of the at least one die and the plurality of pillars are coupled to coupling regions along the second heat sink or dissipation structure. By coupling the plurality of flanges to the respective contacts of the at least one die and the plurality of pillars to the coupling regions along the second heat sink or dissipation structure, the first heat sink or dissipation structure, the second heat sink or dissipation structure, and the at least one die form a pre-formed stacked semiconductor assembly. After the pre-formed stacked semiconductor assembly has been formed, a molding compound is applied to form the first embodiment of the double-sided cooling (DSC) semiconductor package or device.

For example, at last one embodiment of a double-sided cooling (DSC) semiconductor package or device is summarized as including a spacer structure having a non-conductive material in which a plurality of conductive portions (*i.e.,* conductive vias) are present within the non-conductive material. Generally, in this second embodiment, the non-conductive material is a packaging material (*e.g*., a molding compound, epoxy, or some other similar or suitable type of packaging material). The non-conductive material can be provided with any number of shapes to provide optimal performance based on the thermal dissipation requirements of the DSC semiconductor package in which the spacer structure is to be incorporated. The DSC semiconductor package is then formed by coupling together a first heat sink or dissipation structure, at least one die, a second heat dissipation structure, and the spacer structure. The at least one die is stacked on and coupled to the first heat dissipation structure, the spacer is stacked on and coupled to the at least one die, and the second heat dissipation structure is stacked on and coupled to the spacer structure. After the at least one die, the first heat dissipation structure, the spacer, and the second heat dissipation structure are stacked on one another forming a stacked semiconductor assembly, and a molding compound is applied to the stacked semiconductor assembly to form the second embodiment of the double-sided cooling (DSC) semiconductor package or device.

### BRIEF DESCRIPTION OF THE SEVERAL VIEWS OF THE DRAWINGS

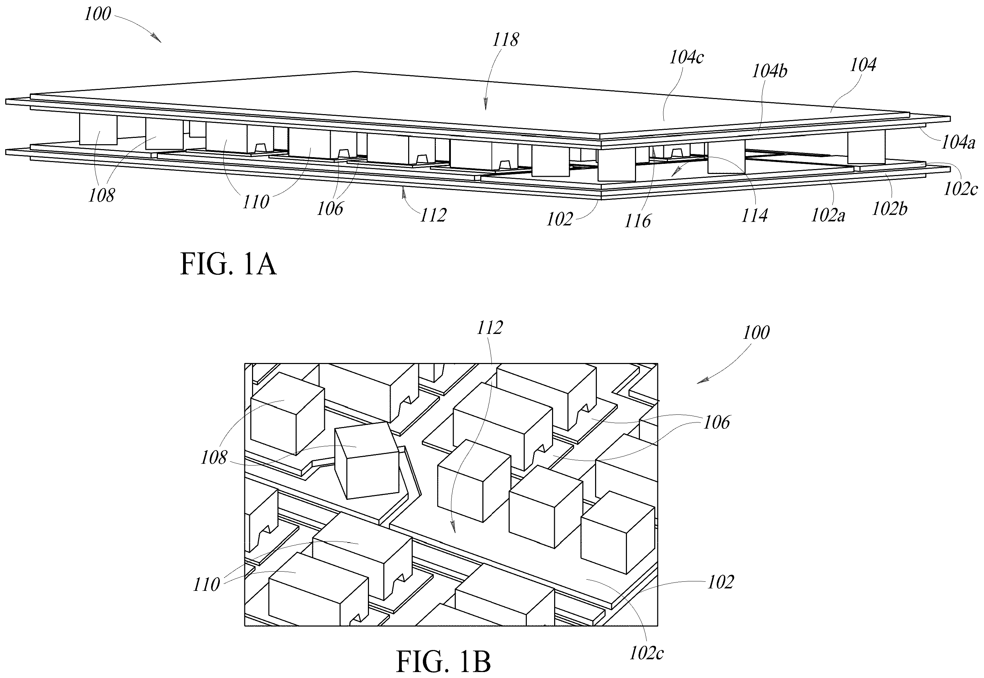

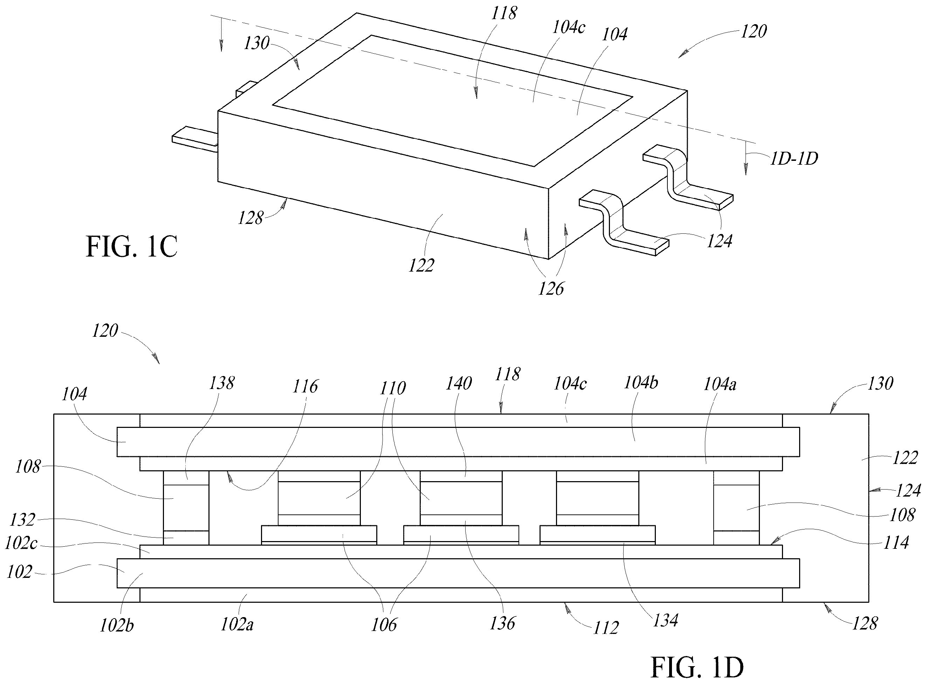

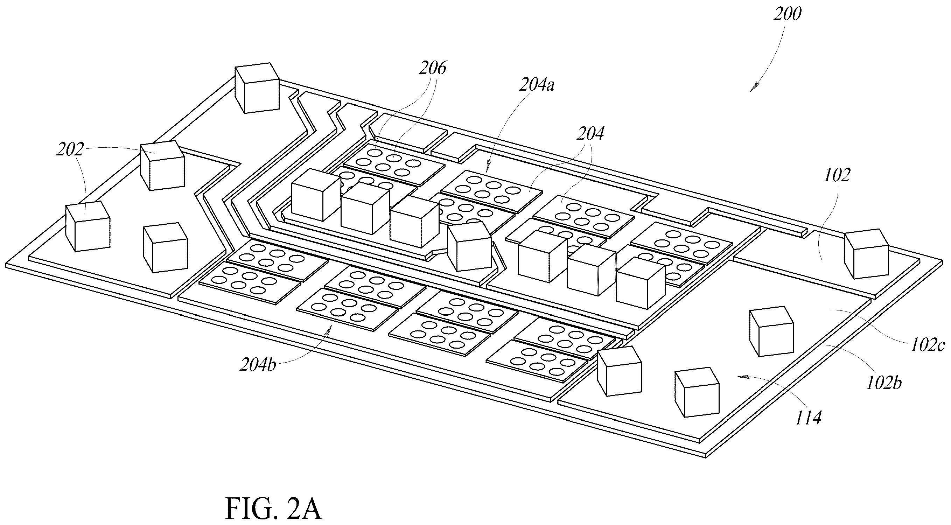

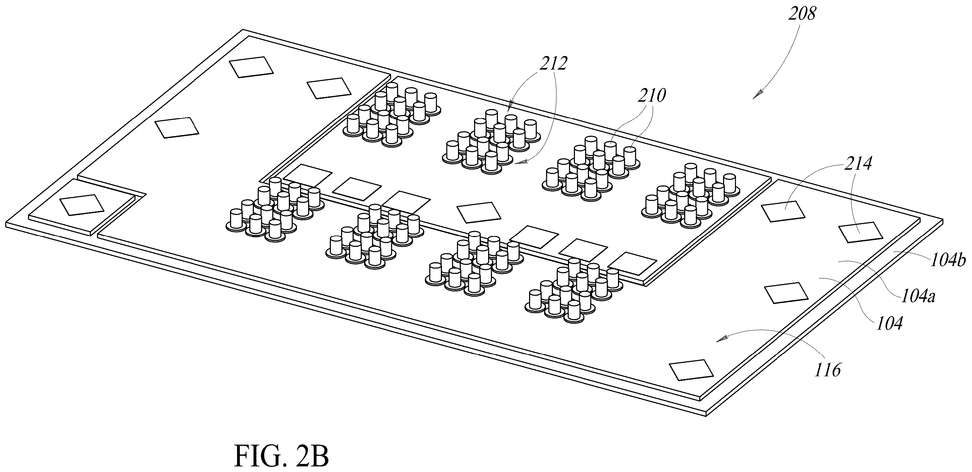

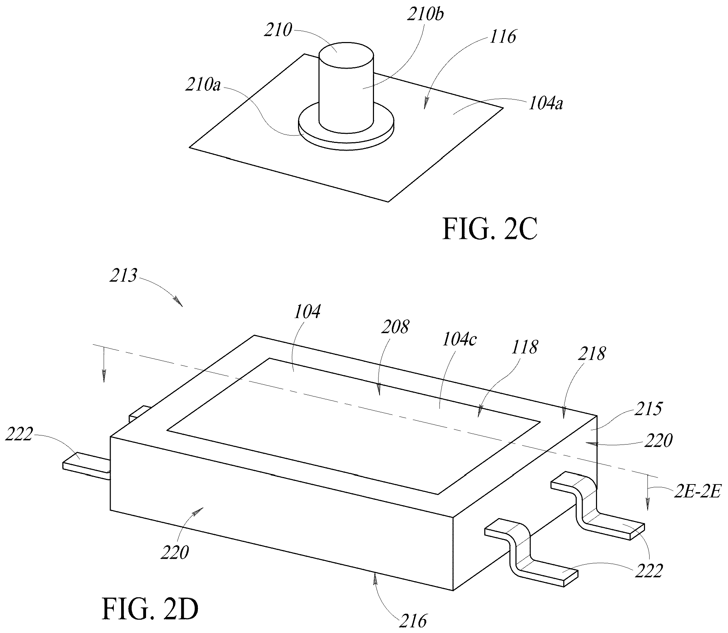

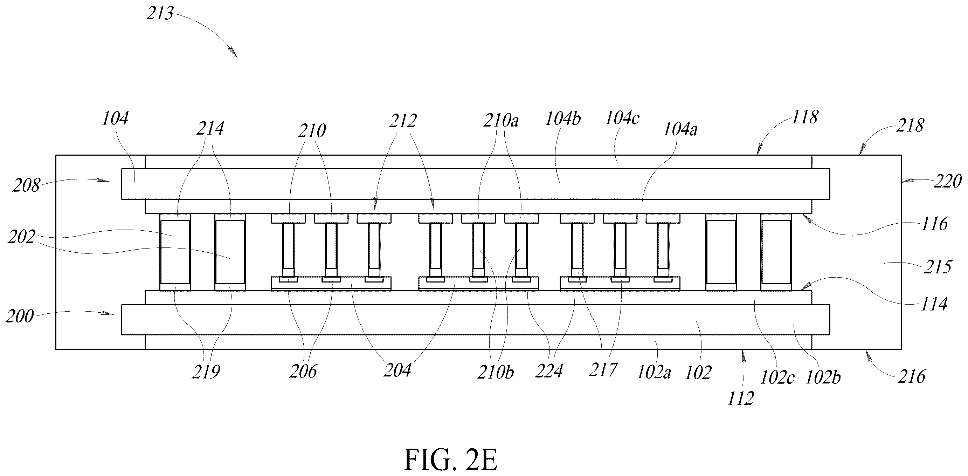

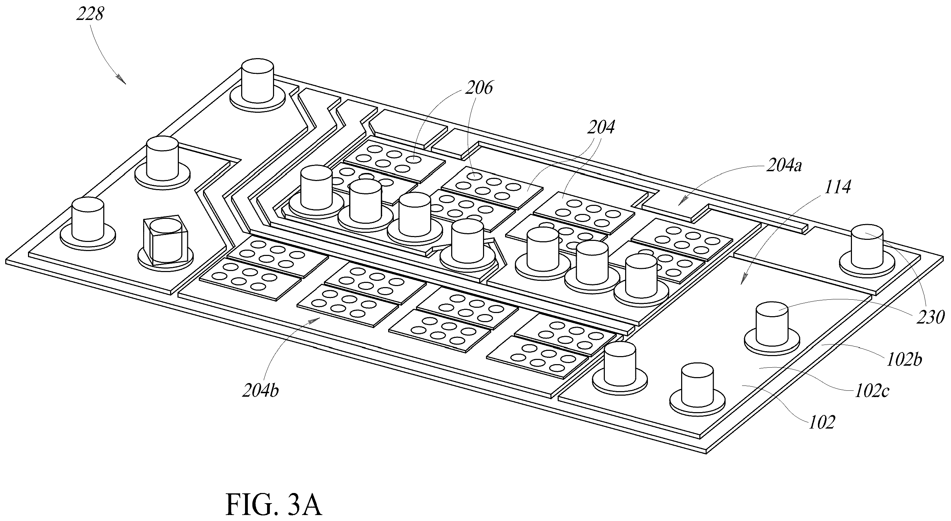

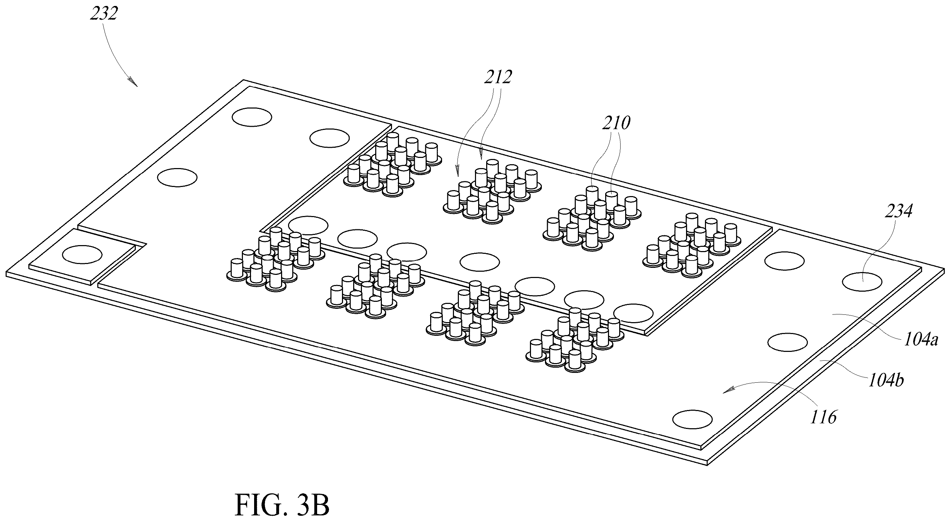

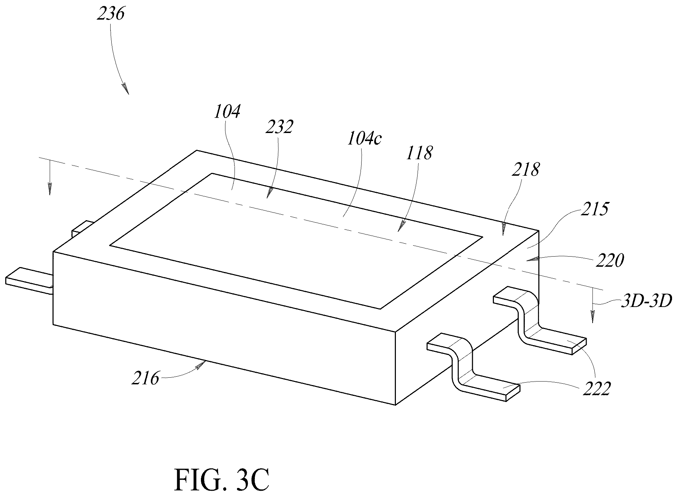

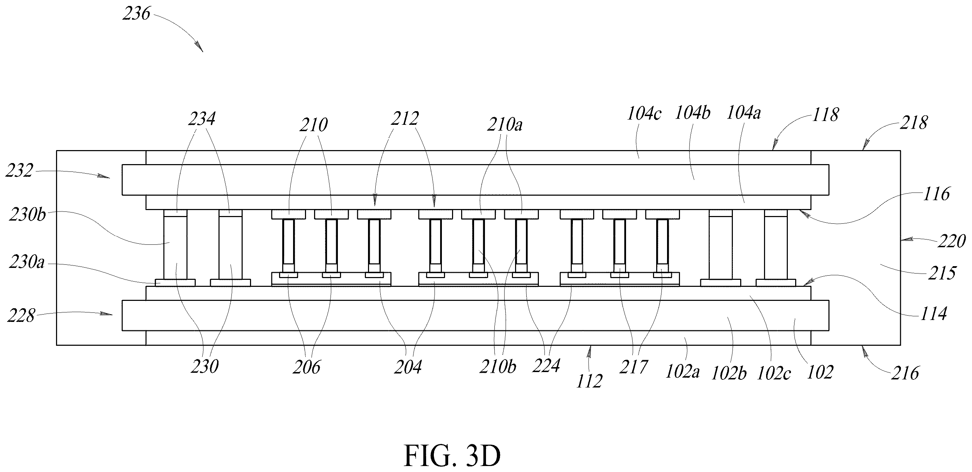

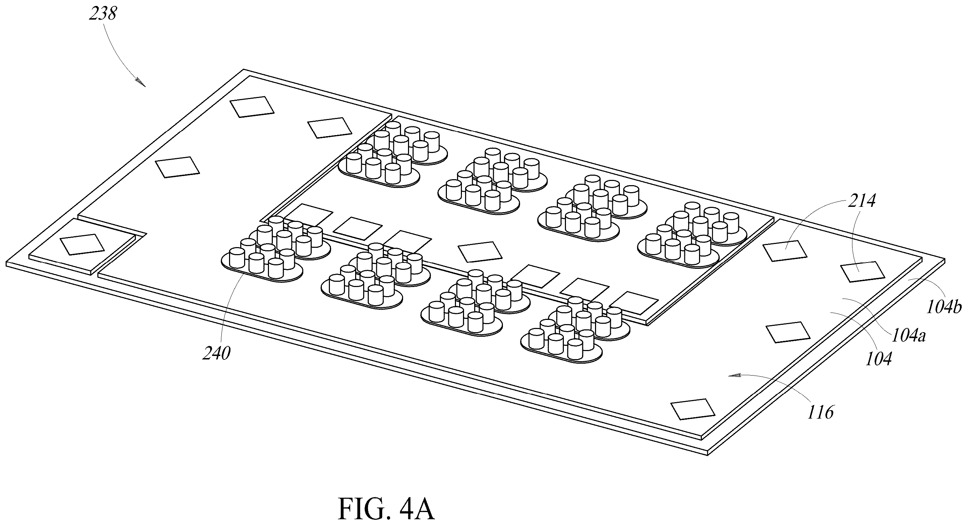

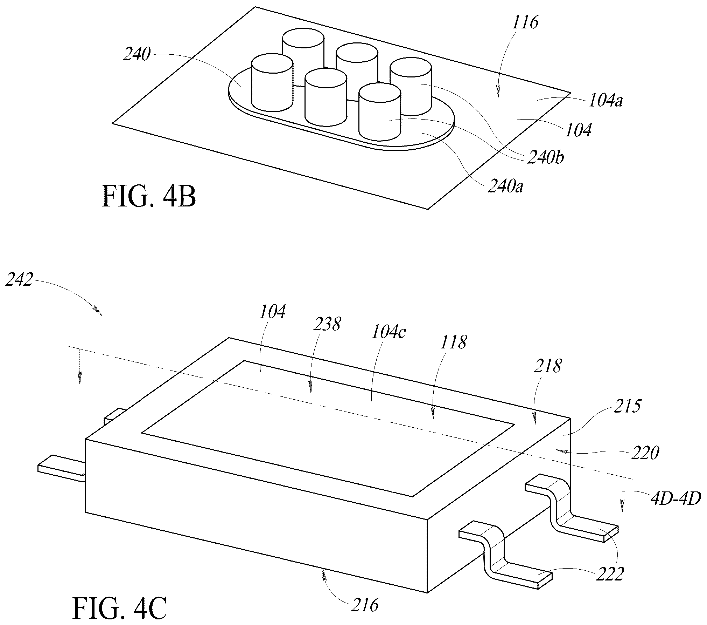

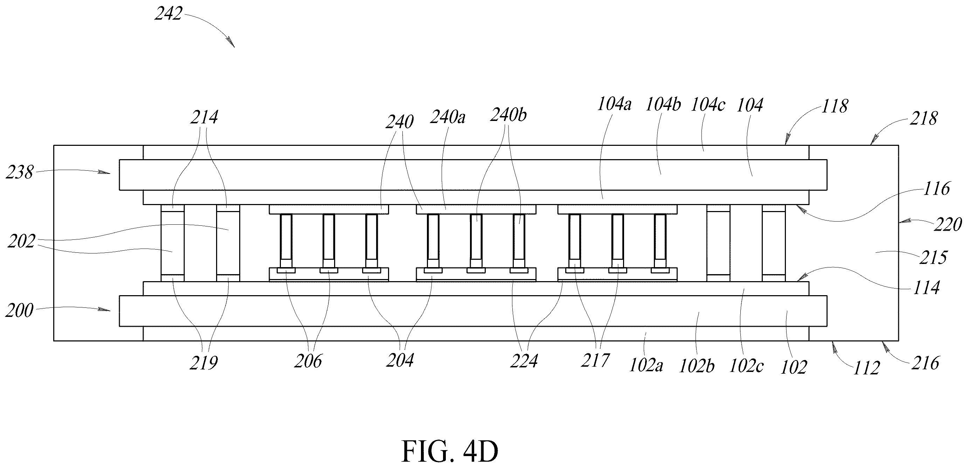

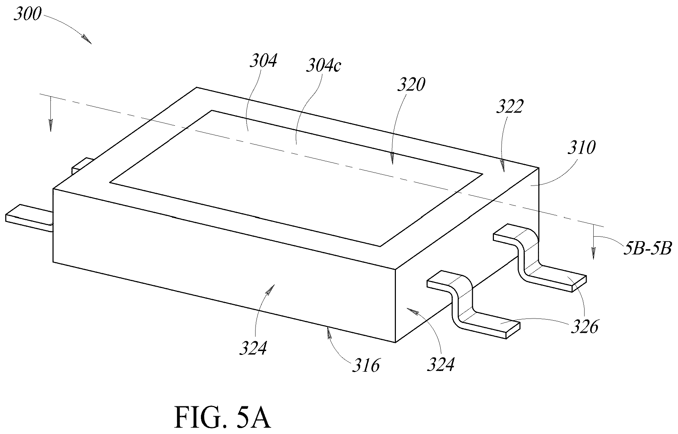

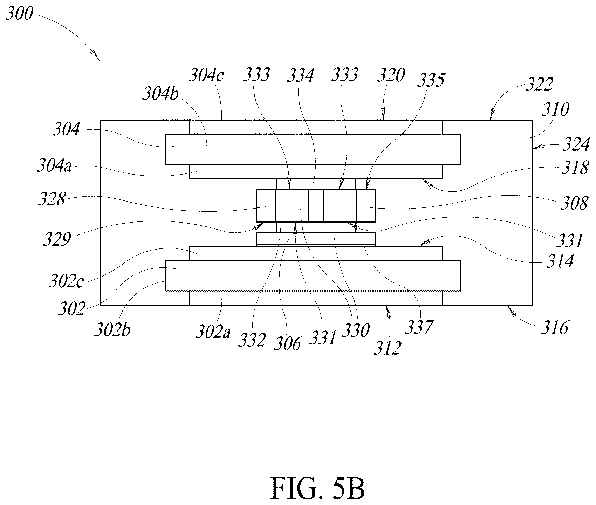

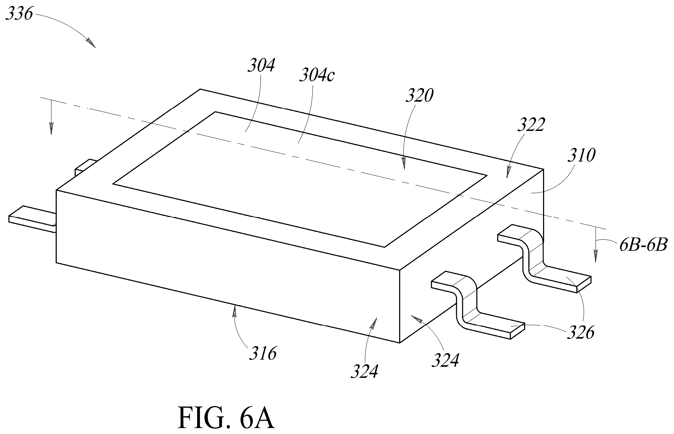

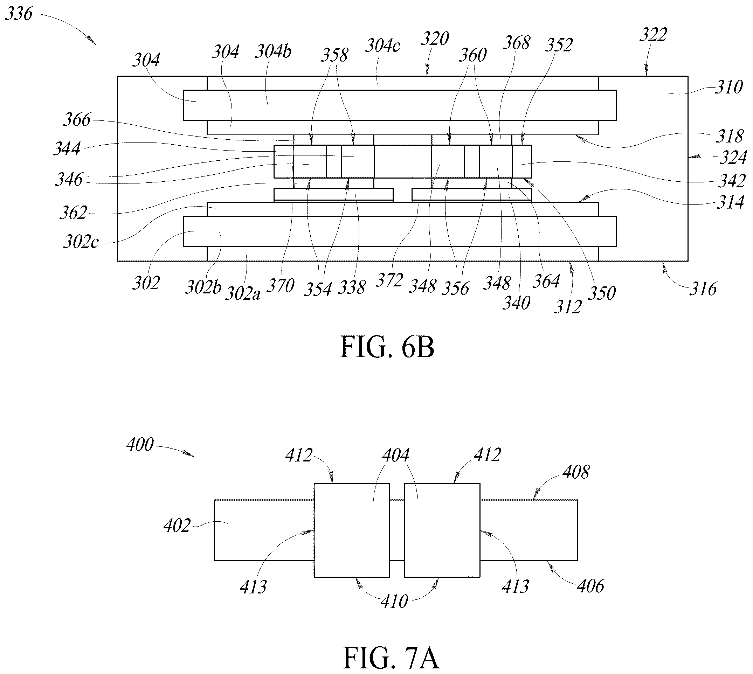

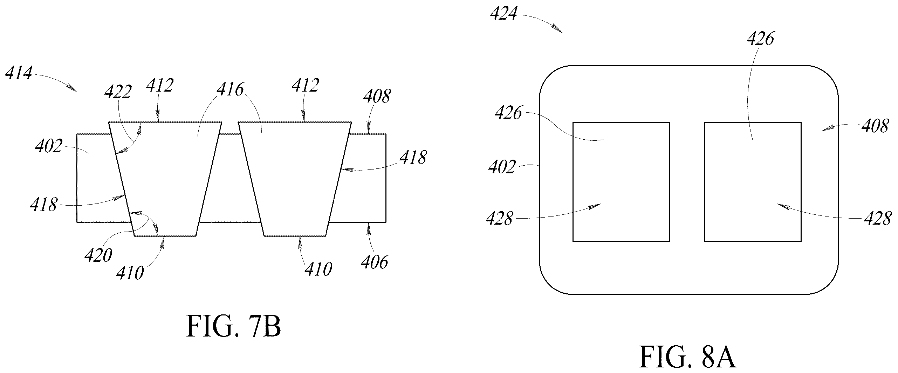

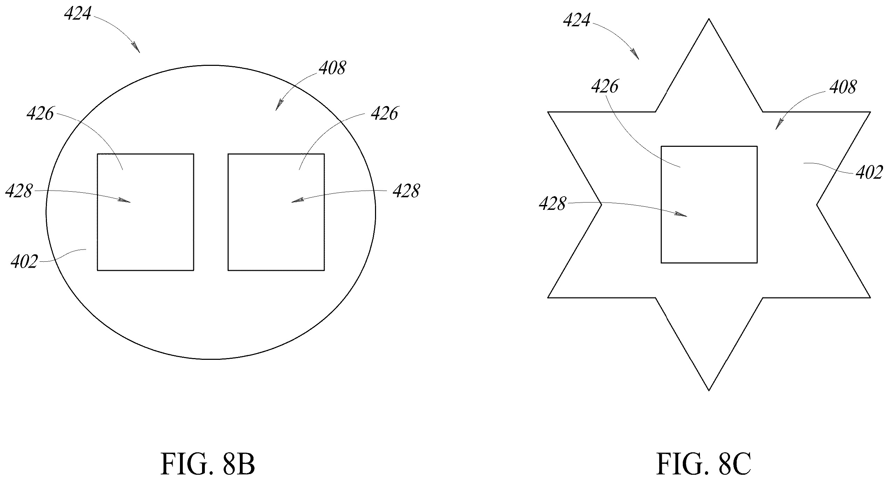

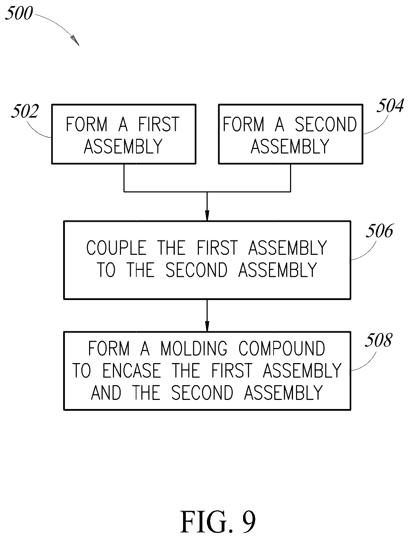

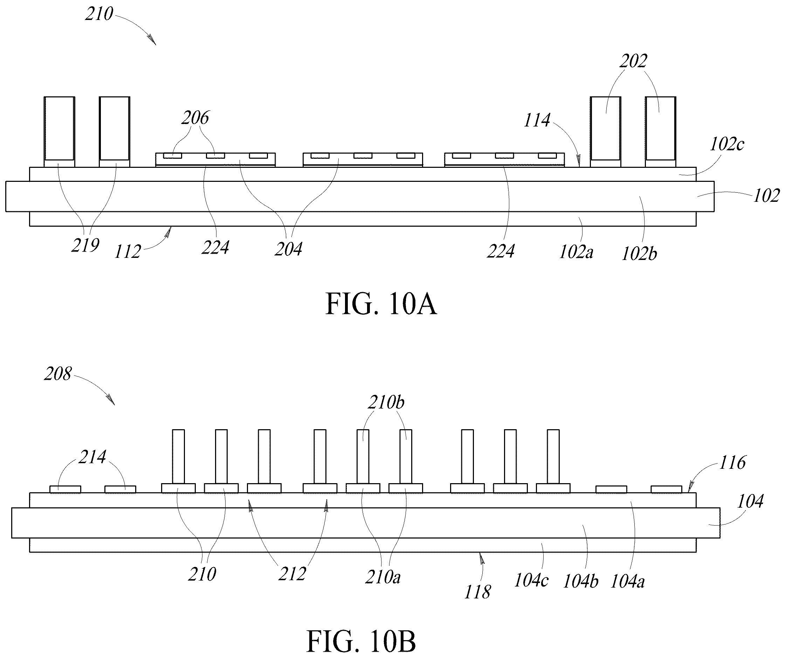

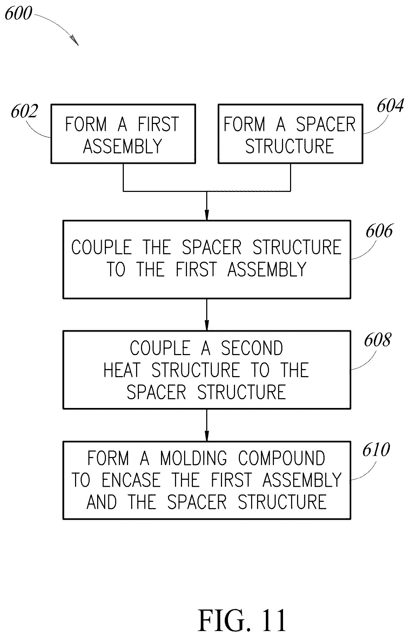

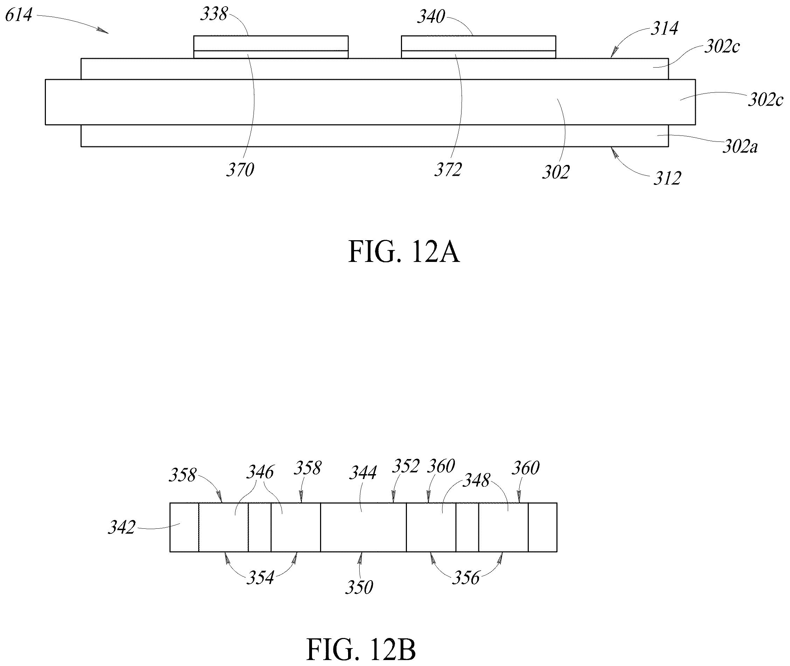

For a better understanding of the embodiments, reference will now be made by way of example to the accompanying drawings. In the drawings, identical reference numbers identify the same as or similar elements or acts unless the context indicates otherwise. The sizes and relative proportions of the elements in the drawings are not necessarily drawn to scale. For example, some of these elements may be enlarged and positioned to improve drawing legibility.
▪ Figure 1A is a perspective view of an example of a semiconductor assembly;
▪ Figure 1B is a zoomed in, enhanced view of a region of the semiconductor assembly as shown in Figure 1A;
▪ Figure 1C is a perspective view of an example of a semiconductor package in which the semiconductor assembly as shown in Figures 1A and 1B is incorporated;
▪ Figure 1D is a cross-sectional view of the semiconductor assembly as shown in Figure 1A taken along line 1D-1D as shown in Figure 1C;
▪ Figure 2A is a perspective view of an embodiment of a first assembly in accordance with some embodiments of the present disclosure;
▪ Figure 2B is a perspective view of an embodiment of a second assembly in accordance with some embodiments of the present disclosure;
▪ Figure 2C is a zoomed in, enhanced view of a respective flange structure of the second assembly as shown in Figure 2B in accordance with some embodiments of the present disclosure;
▪ Figure 2D is a perspective view of an embodiment of a semiconductor package in accordance with some embodiments of the present disclosure;
▪ Figure 2E is a cross-sectional view taken along line 2E-2E of the semiconductor package as shown in Figure 2D in accordance with some embodiments;
▪ Figure 3A is a perspective view of an alternative embodiment of a first assembly in accordance with some embodiments of the present disclosure;
▪ Figure 3B is a perspective view of an alternative embodiment of a second assembly in accordance with some embodiments of the present disclosure;
▪ Figure 3C is a perspective view of an alternative embodiment of a semiconductor package in accordance with some embodiments of the present disclosure;
▪ Figure 3D is a cross-sectional side view taken along line 3D-3D of the semiconductor package as shown in Figure 3C in accordance with some embodiments;
▪ Figure 4A is a perspective view of another alternative embodiment of a second assembly in accordance with some embodiments of the present disclosure;
▪ Figure 4B is a zoomed in, enhanced view of section 4B-4B of a flange structure of the second assembly as shown in Figure 4B in accordance with some embodiments of the present disclosure;
▪ Figure 4C is a perspective view of another alternative embodiment of a semiconductor package in accordance with some embodiments of the present disclosure;
▪ Figure 4D is a cross-sectional side view taken along line 4D-4D of the semiconductor package as shown in Figure 4C in accordance with some embodiments of the present disclosure;
▪ Figure 5A is a perspective view of an embodiment of a semiconductor package with an embodiment of a spacer structure in accordance with some embodiments of the present disclosure;
▪ Figure 5B is a cross-sectional side view taken along line 5B-5B of the semiconductor package as shown in Figure 5A in accordance with some embodiments of the present disclosure;
▪ Figure 6A is a perspective view of an alternative embodiment of a semiconductor package with an alternative embodiment of a spacer structure in accordance with some embodiments of the present disclosure;
▪ Figure 6B is a cross-sectional side view taken along line 6B-6B of the semiconductor package as shown in Figure 6A in accordance with some embodiments of the present disclosure;
▪ Figure 7A is a cross-sectional side view of an another alternative embodiment of a spacer structure in accordance with some embodiments of the present disclosure;
▪ Figure 7B is a cross-sectional side view of an alternative embodiment of a spacer structure in accordance with some embodiments of the present disclosure;
▪ Figure 8A is a top side view of an alternative embodiment of a spacer structure in accordance with some embodiments of the present disclosure;
▪ Figure 8B is a top side view of an alternative embodiment of a spacer structure in accordance with some embodiments of the present disclosure;
▪ Figure 8C is a top side view of an alternative embodiment of a spacer structure in accordance with some embodiments of the present disclosure;
▪ Figure 9 is a flowchart of a method of manufacturing the embodiment of the semiconductor package as shown in Figures 2A-2E in accordance with some embodiments of the present disclosure;
▪ Figures 10A-10D are side views after respective steps have been completed of the flowchart as shown in Figure 9 in accordance with some embodiments of the present disclosure;
▪ Figure 11 is a flowchart of a method of manufacturing the embodiment of the semiconductor package as shown in Figures 5A and 5B in accordance with some embodiments of the present disclosure; and
▪ Figures 12A-12E are side views after respective steps have been completed of the flowchart as shown in Figure 11 in accordance with some embodiments of the present disclosure.

### DETAILED DESCRIPTION

In the following description, certain details are set forth to provide a thorough understanding of various embodiments of devices, methods, and articles. However, one of skill in the art will understand that other embodiments may be practiced without these details. In other instances, well-known structures and methods associated with, for example, semiconductor fabrication processes, etc., have not been shown or described in detail in some figures to avoid unnecessarily obscuring descriptions of the embodiments. Unless the context requires otherwise, throughout the specification and claims which follow, the word "comprise" and variations thereof, such as "comprising," and "comprises," are to be construed in an open, inclusive sense, that is, as "including, but not limited to."

Reference throughout this specification to "one embodiment," or "an embodiment" means that a particular feature, structure or characteristic described in connection with the embodiment is included in at least one embodiment. Thus, the appearances of the phrases "in one embodiment," or "in an embodiment" in various places throughout this specification are not necessarily referring to the same embodiment, or to all embodiments. Furthermore, the particular features, structures, or characteristics may be combined in any suitable manner in one or more embodiments to obtain further embodiments.

The headings are provided for convenience only, and do not interpret the scope or meaning of this disclosure or the claims.

The sizes and relative positions of elements in the drawings are not necessarily drawn to scale. For example, the shapes of various elements and angles may not be drawn to scale, and some of these elements may be enlarged and positioned to improve drawing legibility.

The use of "transverse" means that a surface, a sidewall, or similar or like structure or feature being at an angle with respect to another respective surface, sidewall, or similar or like respective structure or feature. For example, if a first surface is transverse to a first sidewall, the first surface may be at an angle that is equal to 25-degrees, 35-degrees, 45-degrees, 75-degrees, 90-degrees, 120-degrees, and so forth.

Generally, in semiconductor packages or devices one or more heat sinks, slugs, or spreaders are in thermal communication with one or more die within the semiconductor package or devices. In at least some situations, a semiconductor package includes at least a pair of heat dissipation structures (*i.e.,* heat sinks, slugs, or spreaders) that are positioned at opposing or opposite sides of a semiconductor package or device. Between this pair of heat dissipation structures are one or more die. In other words, a first heat dissipation structure of the pair of heat dissipation structures is at a first side (*i.e.,* a lower side) of a semiconductor package, the one or more die are on a respective surface of the first heat dissipation structure, and a second heat dissipation structure of the pair of heat dissipation structures is at a second side (*i.e.,* an upper side) opposite the first side. The one or more die are embedded within a molding compound, the first heat dissipation structure is embedded within the molding compound and includes a first exposed surface that is exposed at the first side from the molding compound, the second heat dissipation structure is embedded within the molding compound and includes a second exposed surface that is exposed at the second side from the molding compound. One or more spacers are between the first heat dissipation structure and the second heat dissipation structure, each respective spacer of the one or more spacers is on a corresponding die of the one or more die. One or more pillars are on the first heat dissipation structure at regions at which the one or more die are not present. The one or more spacers and the one or more pillars provide support and space apart the first heat dissipation structure from the second dissipation structure. Generally, the one or more pillars and the one or more spacers are made of a low CTE material such as a copper molybdenum alloy. Utilizing the copper molybdenum material for use in these one or more spacers and the one or more pillars prevents issues with CTE mismatch such that the likelihood of delamination or the propagation of mechanical defects is reduced, but utilizing the copper molybdenum material is expensive and costly resulting in increased costs in manufacturing the semiconductor packages or devices. In view of the above discussion, while the copper molybdenum spacers and pillars are capable of being utilized to space apart the first heat dissipation structure and the second heat dissipation structure, the present disclosure is directed to providing double-sided cooling (DSC) semiconductor packages that are cheaper while being robust against CTE mismatch to prevent or mitigate the propagation of mechanical defects (*e.g.*, cracking, delamination, or some other similar or like type of defect) when there is an increase in temperature within the DSC semiconductor packages or devices.

Figure 1A is perspective view of a semiconductor assembly, a stacked assembly, or a stacked semiconductor assembly 100 that includes a first heat dissipation structure 102, a second heat dissipation structure 104, a plurality of die 106, a plurality of pillars 108, and a plurality of spacers 110. These various components are stacked on each other in the semiconductor assembly 100 as shown in Figure 1A.

The first heat dissipation structure 102 includes a first layer 102a, a second layer 102b, and a third layer 102c. The first layer 102a is a conductive material, the second layer 102b includes at least one insulating material and includes at least one conductive material, and the third layer 102c includes a conductive material. The first heat dissipation structure 102 includes a first surface 112 and a second surface 114 opposite the first surface.

The second heat dissipation structure 104 includes a first layer 104a, a second layer 104b, and a third layer 104c. The first layer 104a is a conductive material, the second layer 104b includes at least one insulating material and includes at least one conductive material, and the third conductive layer 104c includes a conductive material. The second heat dissipation structure 104 includes a third surface 116 that faces towards the second surface 114 and a fourth surface 118 that is opposite to the third surface 116. The fourth surface 118 faces away from the second surface 114 such that the fourth surface 118 faces away from the first heat dissipation structure 102.

The plurality of die 106 are stacked on and coupled to the second surface 114 of the first heat dissipation structure 102. The plurality of die 106 are stacked on and coupled to the third layer 102c of the first heat dissipation structure 102.

The plurality of spacers 110 are stacked on and coupled to the plurality of die 106. As shown in Figure 1A, each respective spacer 110 of the plurality of spacers 110 has an arced shape. In other words, there is a one-to-one relationship between the plurality of spacers 110 and the plurality of die 106, and each respective spacer 110 of the plurality of spacers 110 is stacked on and coupled to a corresponding die 106 of the plurality of die 106. In other words, respective first ends of the plurality of spacers 110 are coupled to the plurality of die 106.

The plurality of pillars 108 are stacked on and coupled to the second surface 114 of the first heat dissipation structure 102. The plurality of pillars 108 are stacked on and coupled to the third layer 102c of the first heat dissipation structure 102. At least some of the plurality of pillars 108 are set outward from the plurality of die 106 and the plurality of spacers 110, and at least some of the plurality of pillars 108 are between respective groups of the plurality of die 106 and the plurality of spacers 110. In other words, respective first ends of the plurality of pillars 108 are coupled to the second surface 114 of the first heat dissipation structure 102.

The second heat dissipation structure 104 is stacked on the plurality of pillars 108 and the plurality of spacers 110. The first layer 104a of the second heat dissipation structure 104 is stacked on and coupled to respective second ends of the plurality of pillars 108 opposite to the respective first ends of the plurality of pillars 108, and the first layer 104a of the second heat dissipation structure 104 is stacked on and coupled to respective second ends of the plurality of spacers 110 opposite to the respective first ends of the plurality of spacers 110. In other words, the respective second ends of the plurality of pillars 108 and the respective second ends of the plurality of spacers 110 are coupled to the third surface 116 of the second heat dissipation structure 104.

Figure 1B is a zoomed in, enhanced view of a respective region of the semiconductor assembly 100 as shown in Figure 1A with the second heat dissipation structure 104 hidden or removed from the respective second ends of the plurality of pillars 108 and the respective ends of the plurality of spacers 110. As shown in Figure 1B, the plurality of pillars 108 and the plurality of spacers 110 are on the third layer 102c of the first heat dissipation structure 102 and are on the second surface 114 of the first heat dissipation structure 102.

As shown in Figure 1B, each respective spacer 110 of the plurality of spacers 110 is on a corresponding die 106 of the plurality of die 106.

Figure 1C is a perspective view of an example of a semiconductor package 120 in which the semiconductor assembly 100 has been incorporated into by being encased within a molding compound 122 (*e.g.,* a resin, an epoxy, a molding compound, or some other suitable type of packaging material to encase the semiconductor assembly 100 as shown in Figures 1A and 1B). The semiconductor package 120 includes a plurality of leads 124 that extend outward from a plurality of sidewalls 126 of the molding compound 122. The plurality of sidewalls 126 extend between a first surface 128 of the semiconductor package 120 and a second surface 130 of the semiconductor package 120, and the second surface 130 of the semiconductor package 120 is opposite to the first surface 128 of the semiconductor package 120. The plurality of sidewalls 126 the semiconductor package 120 are transverse to the first surface 128 and the second surface 130 of the semiconductor package 120. The first surface 128 of the semiconductor package 120 is defined by the molding compound 122 and the first surface 112 of the first heat dissipation structure 102. The second surface 130 of the semiconductor package 120 is defined by the molding compound 122 and the fourth surface 118 of the second heat dissipation structure 104.

Figure 1D is a cross-sectional view taken along line 1D-1D of the semiconductor package 120 as shown in Figure 1C. As shown in Figure 1D, the first surface 112 of the first heat dissipation structure 102 is co-planar and flush with a lower respective surface of the molding compound 122 defining the first surface 128 of the semiconductor package 120, and the fourth surface 118 of the second heat dissipation structure 104 is co-planar and flush with an upper respective surface of the molding compound 122 defining the second surface 130 of the semiconductor package 120. The first layer 102a of the first heat dissipation structure 102 is exposed at the first surface 128 of the semiconductor package 120, and the third layer 104c of the second heat dissipation structure 104 is exposed at the second surface 130 of the semiconductor package 120.

The respective first ends of the plurality of pillars 108 are coupled to the third layer 102c of the first heat dissipation structure 102 and are coupled to the second surface 114 of the first heat dissipation structure 102 by first portions of a sintered material 132. The plurality of die 106 are coupled to the third layer 102c of the first heat dissipation structure 102 and are coupled to the second surface 114 of the first heat dissipation structure 102 by second portions of a sintered material 134. The respective first ends of the plurality of spacers 110 are coupled to the plurality of die 106 by third portions of a sintered material 136. The respective seconds ends of the plurality of pillars 108 are coupled to the first layer 104a of the second heat dissipation structure 104 and the third surface 116 of the second heat dissipation structure 104 by fourth portions of a sintered material 138. The respective second ends of the plurality of spacers 110 are coupled to the first layer 104a of the second heat dissipation structure 104 and the third surface 116 of the second heat dissipation structure 104 by fifth portions of a sintered material 140.

Generally, the semiconductor package 120 is a double-sided cooling (DSC) package. As the first layer 102a of the first heat dissipation structure 102 and the third layer 104c of the second heat dissipation structure 104 are exposed at the first surface 128 and the second surface 130 of the semiconductor package 120, respectively, the first heat dissipation structure 102 and the second heat dissipation structure 104 are configured to, in operation, dissipate and release thermal energy from within the semiconductor package 120 when there is an increase in temperature internally within the semiconductor package 120. To further facilitate this dissipation of thermal energy from within the semiconductor package 120 through the first heat dissipation structure 102 and the second heat dissipation structure 104, the plurality of pillars 108 and the plurality of spacers 110 are made of a copper molybdenum alloy material. This copper molybdenum alloy material is utilized for the plurality of pillars 108 and the plurality of spacers 110 as the copper molybdenum alloy has a relatively low CTE (coefficient of thermal expansion) relative to other suitable conductive materials. The copper molybdenum alloy having the relatively lower CTE prevents or reduces the likelihood of mechanical defects (*i.e.,* cracking, delamination, or some other similar or like type of mechanical defect) propagating within the semiconductor package 120 due to increase in temperature in the semiconductor package 120 as compared to utilizing other types of conductive materials with a higher CTE. Forming the plurality of pillars 108 and the plurality of spacers 110 may be at least 30 to 35% of direct material cost in manufacturing the semiconductor package 120 (*i.e.,* a double-sided cooling (DSC) semiconductor package) due to utilizing the copper molybdenum alloy to form the plurality of pillars 108 and the plurality of spacers 110. While the use of the copper molybdenum alloy with the low CTE prevents or reduces the likelihood of mechanical defects propagating within the semiconductor package 120, the cost in utilizing the copper molybdenum alloy with the low CTE is relatively high in manufacturing the semiconductor package 120. In view of this discussion, the present disclosure is directed to providing respective embodiments of double-sided cooling (DSC) semiconductor packages that prevent or reduce the likelihood of mechanical defects propagating within the double-sided cooling (DSC) semiconductor packages while being less expensive to manufacture than the semiconductor package 120 including the plurality of pillars 108 and the plurality of spacers 110 that are formed utilizing the copper molybdenum alloy.

Figure 2A is directed to a perspective view of an embodiment of a first assembly 200 in accordance with some embodiments of the present disclosure. As some of the features between the semiconductor assembly 120 and the first assembly 200 are the same, those same or similar features will be provided with the same as or similar reference numerals. The first assembly 200 includes the first heat dissipation structure 102, which includes the first layer 102a, the second layer 102b, and the third layer 102c. A plurality of pillars 202 are coupled to the third layer 102c of the first heat dissipation structure 102 and are coupled to second surface 114 of the first heat dissipation structure 102. In at least one embodiment of the first assembly 200, the plurality of pillars 202 are the same as or similar to the plurality of pillars 108 as discussed earlier herein. The plurality of pillars 202 are pre-coupled or pre-formed on and along the second surface 114 of the first assembly 200.

A plurality of die 204 are coupled to the second surface 114 of the first heat dissipation structure 102 and are coupled to the third layer 102c of the first heat dissipation structure 102. Each respective die 204 of the plurality of die 204 includes one or more respective contacts 206 that are at respective upper surfaces of the plurality of die 204. The plurality of die 204 are pre-coupled to the second surface 114 of the first heat dissipation structure 102 and to the third layer 102c of the first heat dissipation structure 102.

At least some of the plurality of pillars 202 are spaced outward from the plurality of die 204, and at least some of the plurality of pillars 202 are between a first group of die 204a of the plurality of die 204 and a second group of die 204b of the plurality of die 204. Figure 2B is a perspective view of an embodiment of a second assembly 208 in accordance with some embodiments of the present disclosure. As some of the features between the semiconductor assembly 120 and the second assembly 208 are the same, those same or similar features will be provided with the same or similar reference numerals.

The second assembly 208 includes the second heat dissipation structure 104, which includes the first layer 104a, the second layer 104b, and the third layer 104c. A plurality of flange structures 210 are coupled to the third layer 104c. The plurality of flange structures 210 are formed of a conductive material such as a copper molybdenum based material or alloy, a copper based material or alloy, or some other suitable conductive material known to the semiconductor industry. The plurality of flange structures 210 include a plurality of groups 212. In at least this embodiment of the second assembly 208 as shown in Figure 2B, each group 212 of the plurality of groups 212 of the plurality of flanges 210 includes a total of six flanges. In other words, there are six flanges 210 for each of corresponding die 204 of the plurality of die 204. As shown in Figure 2A, in at least this embodiment of the first assembly 200, each respective die 204 of the plurality of die 204 includes six respective contacts that correspond to the six flanges 210 of each group 212 of the plurality of groups 212 of the plurality of flange structures 210. In other words, each respective contact 206 of the plurality of contacts 206 of each respective die 204 of the plurality of die 204 corresponds to a respective flange structure 210 of the plurality of flange structures 210. The plurality flange structures 210 are pre-coupled or pre-welded on and along the third surface 116 and on and along the first layer 104a of the second heat dissipation structure 104.

A plurality of conductive regions 214 are pre-coupled or pre-formed on and along the third surface 116 and on and along the first layer 104a of the second heat dissipation structure 104. In at least one embodiment, the plurality of conductive regions 214 are respective portions of a sintered material. Each conductive region 214 of the plurality of conductive regions 214 corresponds to a corresponding pillar 202 of the plurality of pillars 202. In some embodiments, the plurality of conductive regions are a sintered solder material. Figure 2C is a zoomed in, enhanced view section of a respective flange structure 210 of the plurality of flange structures 210 of the second assembly 208 as shown in Figure 2B in accordance with some embodiments of the present disclosure. The flange structure 210 as shown in Figure 2C includes a first portion 210a and a second portion 210b. The first portion 210a is a base portion that is pre-coupled or pre-welded to the third surface 116 of the second heat dissipation structure 104 and to the first layer 104a of the second heat dissipation structure 104. The second portion 210b is a connection portion. As shown in Figure 2C, the connection portion 210b is less wide than the first portion 210a. In at least this embodiment of the flange structure 210, the first portion 210a has a cylindrical profile and the second portion 210b has a cylindrical profile. However, in at least some alternative embodiments, the first portion 210a and the second portion 210b of the flange structure 210 have a different three-dimensional (3D) profile (*e.g.,* a 3D rectangular profile, a 3D hexagonal profile, or some other suitable 3D profile). While in at least this embodiment as shown in Figure 2C the first portion 210a and the second portion 210b both have a respective cylindrical profile, in at least some alternative embodiments, the first portion 210a and the second portion 210b of the flange structure 210 have different three-dimensional (3D) profiles from each other. For example, in at least one alternative embodiment, the first portion 210a has a rectangular profile and the second portion 210b has a cylindrical profile. The three-dimensional (3D) profiles of the first portion 210a and the second portion 210b are selected to prevent or reduce the likelihood of mechanical defects (*i.e.,* cracking, delamination, or other similar or like type of mechanical defects) from propagating within a manufactured semiconductor package in which the first assembly 200 and the second assembly 208 are incorporated within a molding compound. Figure 2D is a perspective view of an embodiment of a semiconductor package 213 in accordance with some embodiments of the present disclosure. The semiconductor package 213 includes the first assembly 200 and the second assembly 208 which are incorporated in a molding compound 215 *(e.g.,* a resin, an epoxy, a molding compound, or some other suitable type of packaging material to encase the first assembly 200 and the second assembly 208). The molding compound 215 includes a first surface 216, a second surface 218 opposite to the first surface 216, and a plurality of sidewalls 220 that are transverse to the first surface 216 and the second surface 218, and the plurality of sidewalls 220 extend from the first surface 216 to the second surface 218. The fourth surface 118 of the second heat dissipation structure 104 of the second assembly 208 is exposed at the second surface 218 of the molding compound 215. A first side of the semiconductor package 213 is defined by the second surface 218 of the molding compound 215 and the fourth surface 118 of the second heat dissipation structure 104, and a second side (not shown in Figure 2D) of the semiconductor package 213 is defined by the first surface 112 of the first heat dissipation structure 102 and the first surface 216 of the molding compound 215. The semiconductor package 213 further includes a plurality of leads 222 that extend outward from respective sidewalls 220 of the plurality of sidewalls 220 of the molding compound 215.

Figure 2E is a cross-sectional view of the embodiment of the semiconductor package 213 taken along line 2E-2E as shown in Figure 2D in accordance with some embodiments of the present disclosure. As shown in Figure 2E, each respective flange structure 210 of the plurality of flange structures 210 is coupled to a corresponding contact 206 of the plurality of contacts 206 of the plurality of die 204. Each respective second portion 210b of the plurality of flange structures 210 is coupled to a corresponding contact 206 of the plurality of contacts 206 of the plurality of die 204. Respective ends of the second portions 210b of the plurality of flange structures 210 are coupled to the respective contacts 206 of the plurality of die 204 by conductive portions 217. In some embodiments, the conductive portions 217 are at least one of a solder material, a sintered material, or some other type of conductive material configured to couple the respective ends of the second portions 210b of the plurality of flange structures 210 to the contacts 206 of the plurality of die 204.

The plurality of die 204 are coupled to the second surface 114 of the third layer 102c of the first heat dissipation structure 102 by a plurality of adhesive portions 224. In at least some embodiments, the plurality of adhesive portions 224 are portions of a die attach film (DAF). The plurality of pillars 202 are coupled to the second surface 114 of the third layer 102c of the first heat dissipation structure 102 by a plurality of other conductive regions 219. The plurality of other conductive regions 219 are the same as or similar to the plurality of conductive regions 214 as discussed earlier herein. However, unlike the plurality of conductive regions 214 that couple the pillars to the third surface 116 of the first layer 104a of the second heat dissipation structure 104, the plurality of other conductive regions 219 couple the plurality of pillars 202 to the second surface 114 of the first heat dissipation structure 102.

The plurality of pillars 202 are configured to transmit thermal energy from within the semiconductor package 213 to the first and second heat dissipation structures 200, 208 such that the first and second heat dissipation structures 200, 208 can then dissipate the thermal energy from within the semiconductor package 213. The plurality of flange structures 210 are configured to transmit thermal energy from within the semiconductor packages 213 and from the plurality of die 204 such that the second heat dissipation structure 104 can dissipate the thermal energy from within the semiconductor package 213.

The plurality of flange structures 210 are directly pre-coupled or pre-welded to the third surface 116 of the first layer 104a of the second heat dissipation structure 104. In other words, in at least this embodiment, the first portions 210a of the plurality of flange structures 210 are directly and physically coupled to the third surface 116 of the first layer 104a of the second heat dissipation structure 104. In some alternative embodiments, another conductive material can be utilized to pre-couple the first portions 210a of the plurality of flange structures 210 to the third surface 116 of the first layer 104a of the second heat dissipation structure 104.

Figure 3A is a perspective view of an alternative embodiment of a first assembly 228 in accordance with some embodiments of the present disclosure. This alternative embodiment of the first assembly 228 includes several of the same or similar features as the embodiment of the first assembly 200 as shown in Figure 2A. The same or similar features between the alternative embodiment of the first assembly 228 and the embodiment of the first assembly 200 have been provided with the same or similar reference numerals. The discussion of the same or similar features between the alternative embodiment of the first assembly 228 and the embodiment of the first assembly 200 may not be reproduced herein as these same or similar features were discussed in detail earlier herein with respect to the embodiment of the first assembly 200 with respect to Figures 2A-2E of the present disclosure.

As shown in Figure 3A, the alternative embodiment of the first assembly 228 is similar to the embodiment of the first assembly 200 as shown in Figure 2A. However, unlike the embodiment of the first assembly 200, the alternative embodiment of the first assembly 228 includes a plurality of flange structures 230 that have replaced the plurality of pillars 202. In some embodiments, the plurality of flange structures 230 are larger than the plurality of flange structures 210 of the second assembly 208. In other words, each respective flange structure 230 of the plurality of flanges 230 includes a first portion or base portion 230a (see Figure 3D of the present disclosure) similar to the first portion 210a of the flange structure 210 as shown in Figure 2C, and each respective flange structure 230 of the plurality of flange structures 230 includes a second portion 230b (see Figure 3D of the present disclosure) that is less wide than the first portion 230a and extends outward from the first portion 230a. The respective first portions 230a of the plurality of flange structures 230 are pre-coupled or pre-welded to the third surface 116 of the first layer 104a of the second heat dissipation structure 104.

Figure 3B is a perspective view of an alternative embodiment of a second assembly 232 in accordance with some embodiments of the present disclosure. This alternative embodiment of the second assembly 232 includes several of the same or similar features as the embodiment of the second assembly 208 as shown in Figure 2B. The same or similar features between the alternative embodiment of the second assembly 232 and the embodiment of the second assembly 208 have been provided with the same or similar reference numerals. The discussion of the same or similar features between the alternative embodiment of the second assembly 232 and the embodiment of the second assembly 208 may not be reproduced herein as these same or similar features were discussed in detail earlier herein with respect to the embodiment of the second assembly 208 with respect to Figures 2A-2E of the present disclosure.

As shown in Figure 3B, the alternative embodiment of the second assembly 232 is similar to the embodiment of the second assembly 208 as shown in Figure 2B. However, unlike the embodiment of the second assembly 208, the alternative embodiment of the second assembly 232 includes a plurality of conductive regions 234 that are at and along the third surface 116 of the first layer 104a of the second heat dissipation structure 104. Unlike the plurality of connection regions 214 that have a square or rectangular shape as shown in Figure 2A that corresponds to the rectangular or square shape of the plurality of pillars 202 of the second assembly 208, the plurality of conductive regions 234 have a circular shape that corresponds to the circular shape of the second portions 230b of the plurality of flange structures 230. In other words, the plurality of conductive regions 234 have been included in this alternative embodiment of the second assembly 232 and replace the plurality of connection regions 214 as shown in the embodiment of the second assembly 208 as shown in Figure 2B.

Figure 3C is a perspective view of an alternative embodiment of a semiconductor package 236 in accordance with some embodiments of the present disclosure. This alternative embodiment of the semiconductor package 236 includes several of the same or similar features as the embodiment of the semiconductor package 213 as shown in Figure 2D. The same or similar features between the alternative embodiment of the semiconductor package 236 and the embodiment of the semiconductor package 213 have been provided with the same or similar reference numerals. The discussion of the same or similar features between the alternative embodiment of the semiconductor package 236 and the embodiment of the semiconductor package 213 may not be reproduced herein as these same or similar features were discussed in detail earlier herein with respect to the embodiment of the semiconductor package 213 with respect to Figures 2D and 2E of the present disclosure. Unlike the embodiment of the semiconductor package 213 that includes the first assembly 200 and the second assembly 208 as shown in Figures 2D and 2E of the present disclosure, the alternative embodiment of the semiconductor package 236 instead includes the first assembly 228 as shown in Figure 3A and the second assembly 232 as shown in Figure 3B.

Figure 3D is a cross-sectional view of the alternative embodiment of the semiconductor package 236 taken along line 3D-3D as shown in Figure 3C in accordance with some embodiments of the present disclosure. As the alternative embodiment of the semiconductor package 236 includes the first assembly 228 and the second assembly 232, the plurality of flange structures 230 and the plurality of conductive regions 234 are present within the molding compound 215 of the semiconductor package 236. Furthermore, unlike the semiconductor package 213, the plurality of other conductive regions 219 are not present on the third layer 102c of the first heat dissipation structure 102 within this alternative embodiment of the semiconductor package 236. As shown in Figure 3D, unlike the embodiment of the semiconductor package 213 that includes the plurality of pillars 202 and the plurality of conductive regions 214, the alternative embodiment of the semiconductor package 236 instead includes the plurality of flange structures 230 and the plurality of conductive regions 234. In other words, the plurality of flange structures and the plurality of conductive regions 234 have replaced the plurality of pillars 202 and the plurality of conductive regions 214. Furthermore, as shown in Figure 3D, the plurality of other conductive regions 219 are not present within this alternative embodiment of the semiconductor package 236 as the respective first portions 230a of the plurality of flanges 230 have been pre-coupled or pre-welded directly and physically to the second surface 114 of the third layer 102c of the first heat dissipation structure 102 of the first assembly 228. In some alternative embodiments, another conductive material can be utilized to pre-couple the first portions 230a of the plurality of flange structures 230 to the third surface 116 of the first layer 104a of the second heat dissipation structure 104.

As shown in Figure 3D, respective ends of the second portions 230b of the plurality of flange structures 230 are coupled to the first layer 104a of the second heat dissipation structure 104 of the second assembly 232 by the plurality of conductive regions 234. Similar to the plurality of conductive regions 214, the plurality of conductive regions 234 are respective portions of a sintered material. As shown in Figure 3D, the plurality of flange structures 230 are oriented oppositely relative to the plurality of flange structures 210 as the first portions 230a of the plurality of flange structures 230 are on the second surface 114 of the third layer 102c of the first heat dissipation structure 102 of the first assembly 228, and the first portions 210a of the plurality of flange structures 210 are on the third surface 116 of the first layer 104a of the second heat dissipation structure 104 of the second assembly 232.

Figure 4A is a perspective view of another alternative embodiment of the second assembly 238 in accordance with some embodiments of the present disclosure. This another alternative embodiment of the second assembly 238 includes several of the same or similar features as the embodiment of the second assembly 208 as shown in Figure 2B. The same or similar features between the another alternative embodiment of the second assembly 238 and the embodiment of the second assembly 208 have been provided with the same or similar reference numerals. The discussion of the same or similar features between the another alternative embodiment of the second assembly 238 and the embodiment of the second assembly 208 may not be reproduced herein as these same or similar features were discussed in detail earlier herein with respect to the embodiment of the second assembly 208 with respect to Figures 2A-2E of the present disclosure.

As shown in Figure 4A, the another alternative embodiment of the second assembly 238 is similar to the embodiment of the second assembly 208 as shown in Figure 2B. However, unlike the embodiment of the second assembly 208, the another alternative embodiment of the second assembly 238 includes a plurality of multi-flange structures 240 that have replaced the plurality of flange structures 210. Each respective multi-flange structure 240 of the plurality of multi-flange structures 240 includes a first portion 240a (see Figure 4B of the present disclosure) and a plurality of second portions 240b (see Figure 4B of the present disclosure) that are coupled to the first portion 240a and extend outward from the first portion 240a. In other words, for each respective first portion 240a, which may be referred to as base portions, of the plurality of multi-flange structures 240 there are multiple respective second portions 240b extending outward from each respective first portion 240a of the plurality of flange structures 240a.

Figure 4C is a perspective view of another alternative embodiment of a semiconductor package 242 in accordance with some embodiments of the present disclosure. This another alternative embodiment of the semiconductor package 242 includes several of the same or similar features as the embodiment of the semiconductor package 213 as shown in Figure 2D. The same or similar features between the another alternative embodiment of the semiconductor package 242 and the embodiment of the semiconductor package 213 have been provided with the same or similar reference numerals. The discussion of the same or similar features between the another alternative embodiment of the semiconductor package 242 and the embodiment of the semiconductor package 213 may not be reproduced herein as these same or similar features were discussed in detail earlier herein with respect to the embodiment of the semiconductor package 213 with respect to Figures 2D and 2E of the present disclosure. Unlike the embodiment of the semiconductor package 213 that includes the first assembly 200 and the second assembly 208 as shown in Figures 2D and 2E of the present disclosure, the another alternative embodiment of the semiconductor package 242 instead includes the first assembly 200 as shown in Figure 2A and the second assembly 238 as shown in Figure 4A.

Figure 4D is a cross-sectional view of the another alternative embodiment of the semiconductor package 242 taken along line 4D-4D as shown in Figure 4C in accordance with some embodiments of the present disclosure. As the another alternative embodiment of the semiconductor package 242 includes the first assembly 200 and the second assembly 238, the plurality of multi-flange structures 240 and the plurality of conductive regions 214 are present within the molding compound 215 of the semiconductor package 242. Furthermore, similar to the semiconductor package 213, the plurality of other conductive regions 219 are present on the third layer 102c of the first heat dissipation structure 102 within this another alternative embodiment of the semiconductor package 242. As shown in Figure 4D, unlike the embodiment of the semiconductor package 213 that includes the plurality of flange structures 210 that are all individually separate and distinct from each other, the another alternative embodiment of the semiconductor package 242 instead includes the plurality of multi-flange structures 240. In other words, the plurality of multi-flange structures 240 has replaced the plurality of flange structures 210 that are individually separate and distinct from each other. Furthermore, as shown in Figure 4D, the plurality of other conductive regions 219 are present within this another alternative embodiment of the semiconductor package 242 as the plurality of pillars 202 are present between corresponding ones of the plurality of other conductive regions 219 and the plurality of conductive regions 214.

In this another alternative embodiment of the semiconductor package 242, the plurality of multi-flange structures 240 are directly and physically coupled to the third surface 116 of the first layer 104a of the second heat dissipation structure 104. For example, in some embodiments, each respective first portion 240a of the plurality of multi-flange structures 240 are directly and physically coupled to the third surface 116 by a pre-welding process. In some alternative embodiments, another conductive material can be utilized to pre-couple the first portions 240a of the plurality of multi-flange structures 240 to the third surface 116 of the first layer 104a of the second heat dissipation structure 104 of the second assembly 238. While not fully visible in Figure 4D, in at least some embodiments it will be readily appreciated that there is a one-to-one relationship between a number of the plurality of die 204 and a number of the plurality of multi-flange structures 240 such that there is a corresponding multi-flange structure 240 of the plurality of multi-flange structures 240 for each respective die 204 of the plurality of die 204. While not fully visible in Figure 4D, in at least some embodiments it will be readily appreciated that there is a one-to-one relationship between a number of the second portions 240b and a number of contacts 206 of each respective die 204 of the plurality of die 204 such that there is a corresponding second portion 240b of the plurality of multi-flange structures 240 for each contact 206 of each respective die 204 of the plurality of die 204.

As discussed earlier herein with respect to Figure 1A, the one or more pillars 108 and the one or more spacers 110 are made of a low CTE material such as a copper molybdenum alloy. Utilizing the copper molybdenum material for use in these one or more spacers 110 and the one or more pillars 108 prevents issues with CTE mismatch such that the likelihood of delamination or the propagation of mechanical defects is reduced, but utilizing the copper molybdenum material is expensive and costly resulting in increased costs in manufacturing the semiconductor packages or devices. In view of the above discussion, while the copper molybdenum spacers 110 and pillars 108 are capable of being utilized to space apart the first heat dissipation structure 102 and the second heat dissipation structure 104, the embodiments of the semiconductor packages 213, 236, and 242 provide the same robustness against CTE mismatch while also reducing manufacturing costs and expense relative to the manufacturing the semiconductor package 120. For example, the semiconductor package 213 includes the plurality of flange structures 210, the semiconductor package 236 includes the plurality of flange structures 210 and the plurality of flange structures 230, and the semiconductor package 242 includes the plurality of multi-flange structures 240. The plurality of flange structures 210, 230 or the plurality of multi-flange structures 240 replaces at least the plurality of spacers 110 as shown in Figure 1D. The plurality of spacers 110 are generally larger than the plurality of flange structures 210, 230 and the plurality of multi-flange structure 240 such that the plurality of spacers 110 require a greater amount of a copper molybdenum alloy to be formed relative to the plurality of flange structures 210, 230 or the plurality of multi-flange structures 240 when these are made of the copper molybdenum material. Alternatively, as the size and shape of the plurality of flange structures 210, 230 and the plurality of multi-flange structures 240 can be adjusted more readily, in some embodiments, the plurality of flange structures 210, 230 and the plurality of multi-flange structures 240 are made of an alloy material less expensive than the copper molybdenum alloy while still being suitable to dissipate thermal energy generated within the semiconductor packages 213, 236, 242, respectively. In other words, by utilizing the plurality of flanges 210, 230 or the plurality of multi-flanges 240 to replace the plurality of pillars 108 and the plurality of spacers 110, a total expense of manufacturing the embodiments of the semiconductor packages 213, 236, 242 of the present disclosure is less than that of manufacturing the semiconductor package 120 as shown in Figures 1C and 1D and at the same time the robustness of CTE mismatch of the embodiments of the semiconductor packages 213, 236, 242 is equivalent or greater than that the robustness of CTE mismatch of the semiconductor package 120 as shown in Figures 1C and 1D.

Figure 5A is a perspective view of an embodiment of a semiconductor package 300 including a first heat dissipation structure 302, a second heat dissipation structure 304, at least one die 306, and a spacer structure 308 in accordance with some embodiments of the present disclosure. Figure 5B is a cross-sectional view of the embodiment of the semiconductor package 300 taken along line 5B-5B as shown in Figure 5A in accordance with some embodiments of the present disclosure.

As shown in Figure 5A, the semiconductor package 300 includes a molding compound 310 that encases the first heat dissipation structure 302, the second heat dissipation structure 304, the at least one die 306, and the spacer structure 308, which can more readily be seen in Figure 5B of the present disclosure.

The first heat dissipation structure 302 is the same as or similar to the first heat dissipation structure 102. The first heat dissipation structure 302 includes a first layer 302a, a second layer 302b, and a third layer 302c. The second layer 302b is sandwiched between the first layer 302a and the third layer 302c. The first layer 302a is a conductive material, the second layer 302b includes at least one insulating material and includes at least one conductive material, and the third layer 302c includes a conductive material. The first heat dissipation structure 302 includes a first surface 312 of the first layer 302a that is exposed from the molding compound 310 as shown in Figure 5B and a second surface 314 of the third layer 302c opposite to the first surface 312. The first surface 312 of the first layer 302a faces away from the second surface 314 of the third layer 302c. The molding compound 310 includes a first surface 316 from which the first surface 312 of the first layer 302a of the first heat dissipation structure 302 is exposed. In this embodiment of the semiconductor package 300, the first surface 312 of the first layer 302a is flush and co-planar with the first surface 316 of the molding compound 310.

The second heat dissipation structure 304 is the same as or similar to the second heat dissipation structure 104. The second heat dissipation structure 304 includes a first layer 304a, a second layer 304b, and a third layer 304c. The second layer 304b is sandwiched between the first layer 304a and the third layer 302c. The first layer 304a is a conductive material, the second layer 304b includes at least one insulating material and at least one conductive material, and the third layer 304c is a conductive material. The second heat dissipation structure 304 includes a third surface 318 of the first layer 304a and a fourth surface 320 of the third layer 304c that is opposite to the third surface 318 and is exposed from the molding compound 310. The third surface 318 of the first layer 304a faces away from the fourth surface 320 of the third layer 304c. The molding compound 310 includes a second surface 322 from which the fourth surface 320 of the third layer 304c is exposed. In this embodiment of the semiconductor package 300, the fourth surface 320 of the third layer 304c is flush and co-planar with the second surface 322 of the molding compound 310.

A plurality of sidewalls 324 of the molding compound 310 are transverse to the first surface 316 and the second surface 322, and the plurality of sidewalls 324 of the molding compound 310 extend from the first surface 316 to the second surface 322 of the molding compound 310. The second surface 322 of the molding compound 310 is opposite to the first surface 316 of the molding compound 310, and the second surface 322 of the molding compound 310 faces away from the first surface 316 of the molding compound 310. A plurality of leads 326 extend outward from the plurality of sidewalls 324 of the molding compound 310.

The spacer structure 308 embedded within the molding compound 310 of the semiconductor package 300 includes an insulating material 328 and one or more conductive vias 330 that are within the insulating material 328. The one or more conductive vias 330 include one or more first ends 331 that are coplanar with a first surface 329 of the insulting material 328, and the one or more conductive vias 330 include one or more second ends 333 coplanar with a second surface 335 of the insulating material 328 opposite to the first surface 329 of the insulating material 328. The spacer structure 308 is stacked on the at least one die 306. A first portion 332 of a conductive material couples the spacer structure 308 to the at least one die 306 and a second portion 334 of a conductive material couples the spacer structure 308 to the third surface 318 of the first layer 304a of the second heat dissipation structure 304. In at least some embodiments, the first portion 332 and the second portion 334 are made of or formed of a solder material. The one or more conductive vias 330 are in thermal communication with the die 306 through the first portion 332 of the conductive material, and the one or more conductive vias 330 are in thermal communication with the second heat dissipation structure 304 through the second portion 334 of the conductive material. The spacer structure 308 is pre-formed or premanufactured such that the spacer structure 308 is an alternative to the plurality of pillars 202, the plurality of flange structures 210, the plurality of flange structures 230, and the plurality of multi-flange structures 240 as discussed earlier herein with respect to Figures 2A-2E, 3A-3D and 4A-4D, respectively. The spacer structure 308 is provided to allow for thermal energy generated from the at least one die 306 to be thermally dissipated through the second heat dissipation structure 304 through the first portion 332 of conductive material, the one or more conductive vias 330 of the spacer structure 308, and the second portion 334 of the conductive material.

In this embodiment of the semiconductor package 300, the one or more conductive vias 330 includes a pair of the conductive vias 330 that are in thermal communication with the at least one die through the first portion 332 of the conductive material. In some other embodiments of the semiconductor package 300, the one or more conductive vias 330 includes only a single conductive via 330 that corresponds to the at least one die 306 and is in thermal communication with the at least one die 306 through the first portion 332 of the conductive material.

As shown in Figure 5B, the die 306 is coupled to the second surface 314 of the third layer 302c of the first heat dissipation structure 302 by an adhesive portion 337. In at least one embodiment, the adhesive 337 is a die attach film (DAF) or some other suitable material to couple the die 306 to the second surface 314 of the third layer 302c of the first heat dissipation structure 302.

Figure 6A is a perspective view of an alternative embodiment of a semiconductor package 336 including the first heat dissipation structure 302, the second heat dissipation structure 304, a first die 338, a second die 340, and a spacer structure 342 in accordance with some embodiments of the present disclosure. Figure 6B is a cross-sectional view of the embodiment of the semiconductor package 336 taken along line 6B-6B as shown in Figure 6A in accordance with some embodiments of the present disclosure. As this alternative embodiment of the semiconductor package 336 has several of the same or similar features as the embodiment of the semiconductor package 300, those same or similar features have been provided with the same or similar reference numerals. For the sake of simplicity and brevity of the present disclosure, the details of these same or similar features may not be reproduced in detail herein as they were previously described in detail with respect to Figures 5A and 5B.

As shown in Figure 6A, the semiconductor package 336 includes the molding compound 310 that encases the first heat dissipation structure 302, the second heat dissipation structure 304, the first die 338, the second die 340, and the spacer structure 342, which can be more readily seen in Figure 6B of the present disclosure.

The spacer structure 342 in this alternative embodiment of the semiconductor package 336 includes an insulating material 344, one or more first conductive vias 346 within the insulating material 344, and one or more second conductive vias 348 in the insulating material 344. The one or more first conductive vias 330 overlap the first die 338 and the one or more second conductive vias 346 overlap the second die 340. The spacer structure 342 includes a first surface 350 and a second surface 352 opposite to the first surface. The one or more first conductive vias 346 include first ends 354 and the one or more second conductive vias 348 include first ends 356 that are coplanar with the first surface 350. The one or more first conductive vias 346 include second ends 358 opposite to the first ends 354 of the one or more conductive vias 346, and the second ends 358 are coplanar with the second surface 352. The one or more second conductive vias 348 include second ends 360 opposite to the first ends 356 of the one or more second conductive vias 348, and the second ends 360 are coplanar with the second surface 352. A first portion 362 of a conductive material couples the first ends 354 of the one or more conductive vias 346 to the first die 338, a second portion 364 of a conductive material couples the first ends 356 of the one or more second conductive vias 348 to the second die 340, a third portion 366 of a conductive material couples the second ends 358 of the one or more first conductive vias 346 to the third surface 318 of the first layer 304a of the second heat dissipation structure 304, and a fourth portion 368 of conductive material couples the second ends 358 of the one or more second conductive vias 346 to the third surface 318 of the first layer 304a of the second heat dissipation structure 304.

In this embodiment of the semiconductor package 336, the one or more first conductive vias 346 include a pair of the first conductive vias 346 that are in thermal communication with the first die 338 through the first portion 362 of the conductive material, and the pair of the first conductive vias 346 are in thermal communication with the first layer 304a of the second heat dissipation structure 304 through the third portion 366 of the conductive material. In this embodiment of the semiconductor package 336, the one or more second conductive vias 348 include a pair of the second conductive vias 348 that are in thermal communication with the second die 340 through the second portion 364 of the conductive material, and the pair of the second conductive vias 348 are in thermal communication with the first layer 304a of the second heat dissipation structure 304 through the fourth portion 368 of the conductive material. In some other embodiments of the semiconductor package 300, the one or more first conductive vias 346 include only a single first conductive via 346 that corresponds to the first die 338, and the one or more second conductive vias 348 include only a single second conductive via 348 that corresponds to the second die 340. As shown in Figure 6B, the first die 338 is coupled to the second surface 314 of the third layer 302c of the first heat dissipation structure 302 by a first adhesive portion 370, and the second die 340 is coupled to the second surface 314 of the third layer 302c of the first heat dissipation structure 302 by a second adhesive portion 372. In at least one embodiment, the first adhesive portion 370 and the second adhesive portion 372 are a die attach film (DAF) or some other suitable material to couple the first die 338 and the second die 340 to the second surface 314 of the third layer 302c of the first heat dissipation structure 302. Figure 7A is a cross-sectional side view of an embodiment of a spacer structure 400 in accordance with some embodiments of the present disclosure. This embodiment of the spacer structure 400 includes an insulating material 402 and one or more conductive vias 404 present within the insulating material 402. The insulating material 402 includes a first surface 406 and a second surface 408 that is opposite to and faces away from the first surface 406. As shown in Figure 7A, the one or more conductive vias 404 includes a pair of the conductive vias 404. In some alternative embodiments, the one or more conductive vias 404 include a single conductive via or include more than the pair of conductive vias (*i.e.,* three conductive vias, four conductive vias, or any number of conductive vias to provide thermal heat dissipation pathways within a semiconductor package). The one or more conductive vias 404 include first ends 410 that extend outward from the first surface 406 of the insulating material 402. The one or more conductive vias 404 include second ends 412 that are opposite to the first ends 410 and the one or more second ends 412 extend outward from the second surface 408 of the insulating material 402. The first and second ends 410, 412 extend outward from the first and second surfaces 406, 408 of the insulating material 402, respectively, such that when positioning the spacer structure 400 within an embodiment of a semiconductor package of the present disclosure, a conductive material (*e.g.,* the first portion 332 of the conductive material and the second portion 334 of the conductive material) can more readily purchase onto the first ends 410 and the second ends 412 of the one or more conductive vias 404, respectively. The first and second ends 410, 412 protruding from the first and second surfaces 406, 408, respectively, of the insulating material 402 can provide further thermal heat dissipation from within an embodiment of a semiconductor package that includes the spacer structure 400.

The one or more conductive vias 404 each include one or more sidewalls 413 that are transverse to the first ends 410 and the second ends 412. As shown in Figure 7A, the respective sidewalls 413 are perpendicular or orthogonal to the first ends 410 and the second ends 412. The one or more conductive vias 404 can have a rectangular prism profile, a conical prism profile, or any other suitable type of prism profile.

Figure 7B is a cross-sectional view of an alternative embodiment a spacer structure 414 in accordance with some embodiments of the present disclosure. This embodiment of the spacer structure 414 is the same as or similar to the embodiment of the spacer structure 400 as shown in Figure 7A. As this embodiment of the spacer structure 414 includes several of the same or similar features of the embodiment of the spacer structure 400, these same or similar features are provided with the same or similar reference numerals in Figure 7B. Unlike the embodiment of the spacer structure 400 as shown in Figure 7A, this embodiment of the spacer structure 414 includes one or more conductive vias 416 that are tapered in profile. The one or more conductive vias 416 include respective sidewalls 418 that are transverse to the first ends 410 and the second ends 412 of the one or more conductive vias 416. The respective sidewalls 418 are at a first angle 420 relative to the first ends and are at a second angle 422 relative to the second ends 412. The respective sidewalls 418 are not perpendicular to the first ends 410 and the second ends 412. In this embodiment of the spacer structure 414, the first angle 420 is an obtuse angle and the second angle 422 is an acute angle. In other words, the first angle 420 is different from the second angle 422, and, in this embodiment of the spacer structure 414, the first angle 420 is larger than the second angle 422. The one or more conductive vias 416 can have a rectangular prism profile, a conical prism profile, or any other suitable type of prism profile.

Figure 8A is a top view of an embodiment of a spacer structure 424 in accordance with some embodiments. The spacer structure 424 includes the insulating material 402 and includes one or more conductive vias 426 that are within the insulating material 402. In some embodiments, the one or more conductive vias 426 are the same as the one or more conductive vias 404 as shown in Figure 7A. In some embodiments, the one or more conductive vias 426 are the same as the one or more conductive vias 416 as shown in Figure 7B. In some embodiments, the one or more conductive vias 426 have a different profile or shape than the one or more conductive vias 404, 416 as shown in Figures 7A and 7B of the present disclosure. The one or more conductive vias 426 include respective ends 428, which correspond to the second ends 412 as shown in Figures 7A and 7B, that are exposed from the second surface 408 of the insulating material 402. As shown in Figure 7A, the insulating material 402 has a rectangular profile with rounded corners. In some alternative embodiments of the spacer structure 424, the one or more conductive vias 426 include a single conductive via or include more than two conductive vias. In some alternative embodiments, the respective ends 428 of the one or more conductive vias 426 have a circular profile, have a diamond profile, have a star profile, or have some other n-polygon profile.

Figure 8B is a top view of an alternative embodiment of the spacer structure 424 in accordance with some embodiments. As shown in Figure 8B, the one or more conductive vias 426 are the same as those as shown in Figure 8A. However, unlike the embodiment of the spacer structure 424 as shown in Figure 8A, this alternative embodiment of the spacer structure 424 includes the insulating material 402 in a circular profile instead of a rectangular profile with rounded corners as shown in Figures 8A.

Figure 8C is a top view of an alternative embodiment of the spacer structure 424 in accordance with some embodiments. As shown in Figure 8C, this alternative embodiment of the spacer structure 424 includes the one or more conductive vias 426, but only includes a single conductive via 426 unlike the embodiments of the spacer structures 424 as those as shown in Figure 8A and 8B of the present disclosure. However, unlike the embodiment of the spacer structure 424 as shown in Figure 8A, this alternative embodiment of the spacer structure 424 includes the insulating material 402 in a star profile instead of the circular profile as shown in Figure 8B and the rectangular profile with rounded corners as shown in Figures 8A.

In view of the above discussion, the insulating material 402 of the various embodiments of the spacer structure 424 is capable of being adjusted and changed as desired for use within various embodiments within the scope of semiconductor packages of the present disclosure. As the spacer structures 424 are pre-formed in advance of being incorporated into the various embodiments of the semiconductor packages of the present disclosure, the various embodiments of the spacer structures 424 within the scope of the present disclosure can be provided with any shape or profile to optimize heat dissipation within the double-sided cooling (DSC) semiconductor package in which the spacer structure 424 is incorporated. As discussed earlier herein with respect to Figure 1A, the one or more pillars 108 and the one or more spacers 110 are made of a low CTE material such as a copper molybdenum alloy. Utilizing the copper molybdenum material for use in these one or more spacers 110 and the one or more pillars 108 prevents issues with CTE mismatch such that the likelihood of delamination or the propagation of mechanical defects is reduced, but utilizing the copper molybdenum material is expensive and costly resulting in increased costs in manufacturing the semiconductor packages or devices. In view of the above discussion, while the copper molybdenum spacers 110 and pillars 108 are capable of being utilized to space apart the first heat dissipation structure 102 and the second heat dissipation structure 104, the embodiments of the semiconductor packages 300, 336 provide the same robustness against CTE mismatch while also reducing manufacturing costs and expense relative to the manufacturing the semiconductor package 120. For example, the semiconductor package 300 includes the spacer structure 308 and the semiconductor package 336 includes the spacer structure 342. The spacer structures 308, 342 replace at least the plurality of spacers 110 as shown in Figure 1D. The plurality of spacers 110 are generally larger than the one or more conductive vias 330, 346, 348 within the insulating material 328, 344 of the spacer structures 308, 342, respectively, such that the plurality of spacers 110 require a greater amount of a copper molybdenum alloy to be formed relative to the one or more conductive vias 330, 346, 348 when these are made of the copper molybdenum material. Alternatively, as the size and shape of the one or more conductive vias 330, 346, 348 and the insulating material 328, 344 of the spacer structures 308, 342 can be adjusted more readily (*see, e.g*., embodiments of spacer structures 424 as shown in Figures 8A-8C of the present disclosure), in some embodiments, the one or more conductive vias 330, 346, 348 are made of an alloy material less expensive than the copper molybdenum alloy while still being suitable to dissipate thermal energy generated within the semiconductor packages 300, 336, respectively. In other words, by utilizing the spacer structures 308, 342 including the one or more conductive vias 330, 346, 348 within the insulating material 328, 344, respectively, to replace at least the plurality of spacers 110, a total expense of manufacturing the embodiments of the semiconductor packages 300, 336 of the present disclosure is less than that of manufacturing the semiconductor package 120 as shown in Figures 1C and 1D and at the same time the robustness of CTE mismatch of the embodiments of the semiconductor packages 300, 336 is equivalent or greater than that the robustness of CTE mismatch of the semiconductor package 120 as shown in Figures 1C and 1D.

Figure 9 is directed to a flowchart 500 of an embodiment of a method of manufacturing the embodiment of the semiconductor package 213 as shown in Figure 2D of the present disclosure. The flowchart 500 includes a first step 502, a second step 504, a third step 506, and a fourth step 508. Figures 10A-10D are directed to various cross-sectional views at various points during the method of manufacturing set forth in the flowchart 500 as shown in Figure 9.

In the first step 502, the first assembly 200 is formed. The first assembly 200 is formed by coupling the die 204 to the second surface 114 of the third layer 102c of the first heat dissipation structure 102 through the adhesive portions 224. For example, the adhesive portions 224 are applied to respective rear surfaces of the plurality of die 204 and the plurality of die 204 are placed onto the second surface 114 by a pick and place machine. The plurality of other conductive regions 219 are formed on the second surface 114 of the first layer 102c of the first heat dissipation structure 102. The plurality of pillars 202 are coupled to the plurality of other conductive regions 219 by a sintering process such that the plurality of conductive regions 219 are a sintered material coupling the plurality of pillars 202 to the second surface 114 of the first layer 102c of the first heat dissipation structure 102. In an alternative embodiment, the plurality of pillars 202 are instead integral with the third layer 102c of the first heat dissipation structure 102 such that the plurality of pillars 202 are part of the third layer 102c of the first heat dissipation structure 102. When the plurality of pillars 202 are integral and are part of the third layer 102c of the first heat dissipation structure 102, the plurality of other conductive regions 219 are not present. The result of forming the first assembly 200 is readily visible in Figure 10A.

In the second step 504, the second assembly 208 is formed. The second assembly 208 is formed by forming the plurality of conductive regions 214 to the third surface 116 of the first layer 104a of the second heat dissipation structure 104. Each respective conductive region 214 of the plurality of conductive regions 214 is a conductive pre-sintered material. The plurality of flange structures 210 are coupled to the third surface 116 of the first layer 104a of the second heat dissipation structure 104. The plurality of flange structures 210 are welded to the third surface 116 of the first layer 104a of the second heat dissipation structure 104. For example, in at least one embodiment, the first portions 210a of the plurality of flange structures 210 are ultrasonically welded to the third surface 116 of the first layer 104a of the second heat dissipation structure 104. The result of forming the second assembly 208 is readily visible in Figure 10B.

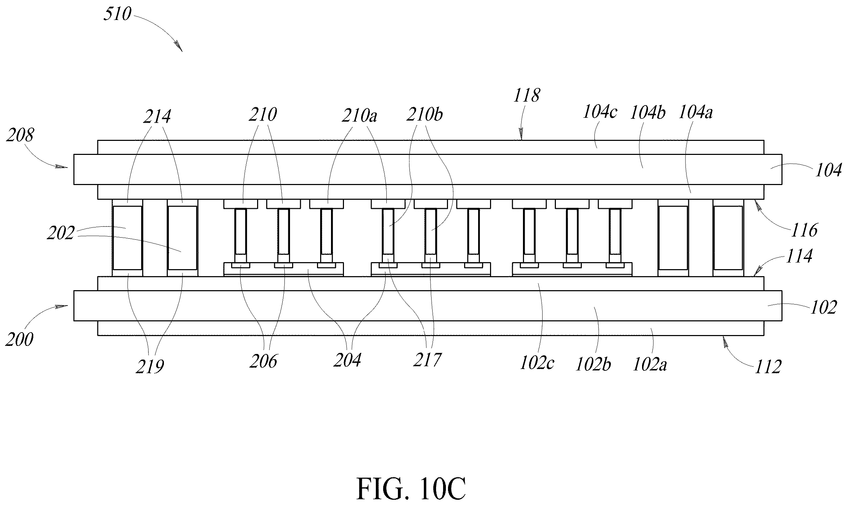

After the first step 502 and the second step 504 in which the first assembly 200 and the second assembly 208 are formed, in a third step 506 the first assembly 200 and the second assembly 208 are stacked and coupled together. In the third step 506, the second assembly 208 is stacked on the first assembly 200 forming an intermediate assembly 510 as shown in Figure 10C. In some embodiments, the conductive portions 217 are formed on the plurality of contacts 206 of the plurality of die 204 before the second assembly 208 is stacked on the first assembly 200. In some embodiments, the conductive portions 217 are instead formed on respective ends surfaces of the respective second portions 210b of the plurality of flange structures 210 before the second assembly 208 is stacked on the first assembly 200. When the second assembly 208 is stacked on the first assembly 200, the plurality of pillars 202 is coupled to the plurality of conductive regions 214 and the pre-sintered material of the plurality of conductive regions 214 and the plurality of conductive portions 217 is sintered or cured coupling the plurality of pillars 202 between the third layer 102c of the first heat dissipation structure 102 and the first layer 104a of the second heat dissipation structure 104. The result of the third step 506 in stacking and coupling together the first assembly 200 and the second assembly 208 is readily visible in Figure 10C such that the intermediate assembly 510 is formed.

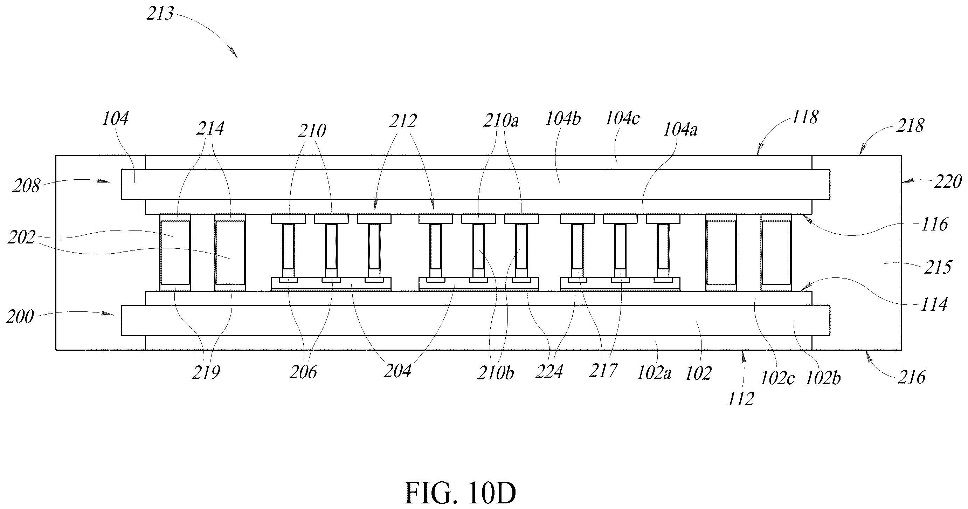

After the third step 506 in which the intermediate structure 510 is formed, in a fourth step 508 the molding compound 215 is formed encasing the intermediate structure 510. The molding compound 215 is formed with at least one of a molding compound injection technique, a molding compound compression technique, or some other suitable formation process for forming the molding compound 215 encasing the intermediate structure 510 within the molding compound 215. After the molding compound 215 has been formed, the semiconductor package 213 as shown in Figure 2E has been formed. It will be readily appreciated that Figure 10D is a reproduction of the semiconductor package 213 as shown in Figure 2E as a result of manufacturing the semiconductor package 213 with the method of manufacturing as set forth in the flowchart 500.

In view of the above discussion, when the plurality of flange structures 230 are utilized instead of the plurality of pillars 202, the plurality of flange structures 230 are coupled to the second surface 114 of the third layer 102c of the first heat dissipation structure 102. When the plurality of flange structures 230 are utilized instead of the plurality of pillars 202, the plurality of other conductive regions 219 are not formed on the second surface 114 of the third layer 102c of the first heat dissipation structure 102, and, instead, the first portions 230a of the plurality of flange structures 230 are ultrasonically welded to the second surface 114 of the third layer 102c of the first heat dissipation structure 102 similar to how the first portions 210a of the plurality of flange structures 210 are ultrasonically welded to the third surface 116 of the first layer 104a of the second heat dissipation structure 104. Utilizing the plurality of flange structures 230 instead of the plurality of pillars 202 results in forming the semiconductor package 236 as shown in Figure 3D of the present disclosure.

In view of the above discussion, when the plurality of multi-flange structures 240 are utilized instead of the plurality of flange structures 210, the plurality of multi-flange structures 240 are coupled to the third surface 116 of the first layer 104a of the second heat dissipation structure 104. When the plurality of multi-flange structures 240 are utilized instead of the plurality of flange structures 210, the first portions 240a of the plurality of multi-flange structures 240 are ultrasonically welded to the third surface 116 of the first layer 104a of the first heat dissipation structure 102 similar to how the first portions 210a of the plurality of flange structures 210 are ultrasonically welded to the third surface 116 of the first layer 104a of the second heat dissipation structure 104. Utilizing the plurality of multi-flange structures 240 instead of the plurality of flange structures 210 results in forming the semiconductor package 242 as shown in Figure 4D of the present disclosure. Figure 11 is directed to a flowchart 600 of an embodiment of a method of manufacturing the embodiment of the semiconductor package 336 as shown in Figure 6B of the present disclosure. The flowchart 600 includes a first step 602, a second step 604, a third step 606, a fourth step 608, and a fifth step 610. Figures 12A-12E are directed to various cross-sectional views at various points during the method of manufacturing set forth in the flowchart 600 as shown in Figure 11.

In the first step 602, a first assembly 614 is formed as shown in Figure 12A. The first assembly 614 is formed to include the first die 338, the second die 340, and the first heat dissipation structure 302 as shown in Figure 6B of the present disclosure. The first die 338 is coupled to the second surface 314 of the third layer 302c of the first heat dissipation structure 302 by the first adhesive portion 370, and the second die 340 is coupled to the second surface 314 of the third layer 302c of the first heat dissipation structure 302 by the second adhesive portion 372. In some embodiments, the first adhesive portion 370 and the second adhesive portion 372 are formed on rear sides of the first die 338 and the second die 340, respectively, such that the first adhesive portion 370 and the second adhesive portion 372 are then utilized to couple to the first die 338 and the second die 340 to the second surface 314 of the third layer 302c of the first heat dissipation structure 302 by a pick and place machine. In some embodiments, the first adhesive portion 370 and the second adhesive portion 372 are formed on the second surface 314 of the third layer 302c of the first heat dissipation structure 302, and, after the first adhesive portion 370 and the second adhesive portion 372 have been formed, the first die 338 and the second die 340 are placed on the first adhesive portion 370 and the second adhesive portion 372, respectively, by a pick and place machine coupling the first die 338 and the second die 340 to the second surface 314 of the first heat dissipation structure 302.

In the second step 604, the spacer structure 342 is formed. In at least one embodiment, the spacer structure 342 is formed by forming one or more openings (not shown) in the insulating material 344. The one or more openings are formed extending entirely through the insulating material 344. In other words, the openings extend from the first surface 350 to the second surface 352. Once the openings a formed, a conductive material is formed within the openings forming the one or more first and second conductive vias 346, 348. When forming the conductive material in the one or more openings to form the one or more first and second conductive vias 346, 348, in at least one embodiment, the insulating material 344 is present on a support. In other words, the first surface 350 of the insulating material 344 is present on the support such that the support closes off the one or more openings at the first surface 350 of the insulating material 344. The conductive material is then grown or deposited within the one or more openings and on a respective surface of the support resulting in the conductive material filling the one or more openings forming the one or more first and second conductive vias 346, 348 within the one or more openings.

Once the conductive material has been grown or deposited within the one or more openings, the conductive material is allowed to cure to form the one or more first and second conductive vias 346, 348 . Once the one or more first and second conductive vias 346, 348 have been formed within the insulating material 344, the insulating material 344 and the one or more first and second conductive vias 346, 348 are removed from the support resulting in the formation of the spacer structure 342 as shown in Figure 12B of the present disclosure. The spacer structure 342 formed is the spacer structure 342 that was discussed earlier and incorporated in the semiconductor package 336 as shown in Figure 6B of the present disclosure.

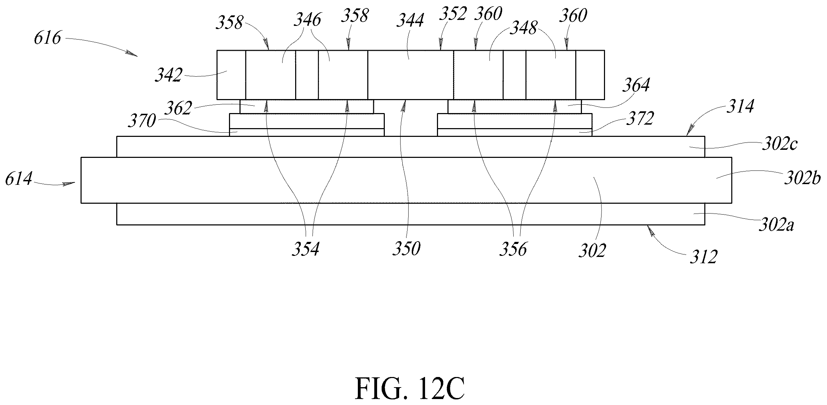

After the first step 602 in which the first assembly 614 has been formed and the second step 604 in which the spacer structure 342 has been formed, in the third step 606 the spacer structure 342 is stacked on and coupled to the first assembly 614 forming an intermediate assembly 616 as shown in Figure 12C. The spacer structure 342 is coupled to the first die 338 and the second die 340 by the first portion 362 of the conductive material and by the second portion 364 of the conductive material, respectively. The one or more first conductive vias 346 overlap the first die 338 and are coupled to an upper surface of the first die 338 by the first portion 362 of the conductive material, and the one or more second conductive vias 348 overlap the second die 340 and are coupled to an upper surface of the second die 340 by the second portion 364 of the conductive material. In some embodiments, the first portion 362 of the conductive material is formed on the upper surface of the first die 338 and the second portion 364 of the conductive material is formed on the upper surface of the second die 340, and, after the first and second portions 362, 364 have been formed, the spacer structure 342 is placed on the first and second portions 362, 364 and the first and second portions 362, 364 are cured or sintered to be hardened coupling the spacer structure to the upper surfaces of the first die 338 and the second die 340 through the first and second portions 362, 364, respectively. In at least some alternative embodiments, the first portion 362 and the second portion 364 are formed instead on the first ends 354, 356 of the one or more first and second conductive vias 346, 348 and on the first surface 350 of the insulating material 344 and then the spacer structure 340 and the first and second portions 362, 364 are pressed downward and onto the respective upper surfaces of the first die 338 and the second die 340, and, once the spacer structure 342 and the first and second portions 362, 364 have been pressed onto the respective upper surface of the first and second die 338, 340, the first and second portions 362, 364 are allowed to cure and harden resulting in the spacer structure 342 being coupled to the respective upper surface of the first and second die 338, 340 through the first and second portions 362, 364.

The results of coupling the spacer structure 342 to the first assembly 614 is readily visible in Figure 12C such that the intermediate assembly 616 is formed.

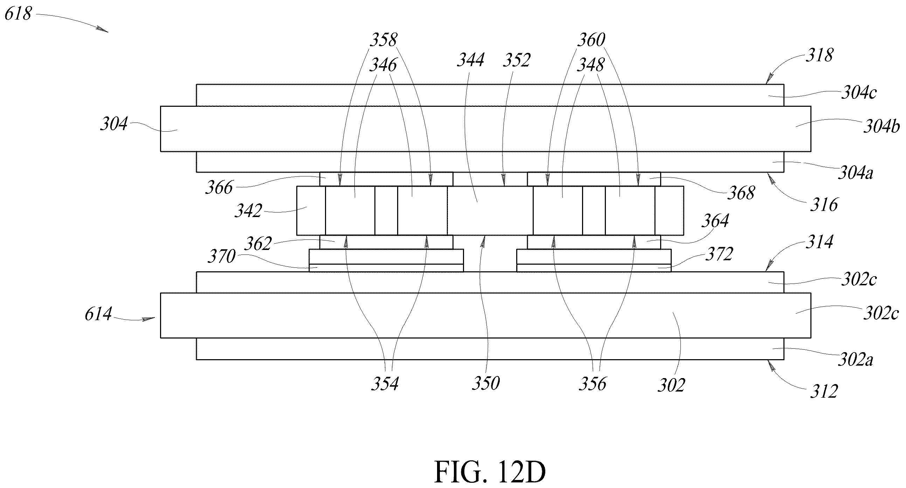

After the third step 606 in which the spacer structure 342 has been coupled to the first assembly 614 forming the intermediate assembly 616, in a fourth step 608 the second heat dissipation structure 304 is stacked on and coupled to the spacer structure 342 of the intermediate assembly 614. The third surface 318 of the first layer 304a of the second heat dissipation structure 304 is coupled to the spacer structure 342 by a third portion 366 of a conductive material and a fourth portion 368 of a conductive material. In some embodiments, the third portion 366 of the conductive material and the fourth portion 368 of the conductive material are formed on the spacer structure 342 and the second heat dissipation structure 304 is then placed onto the third portion 366 and the fourth portion 368, and, once the second heat dissipation structure 304 is in place, the third portion 366 and the fourth portion 368 are allowed to cure and harden coupling the third surface 318 of the second heat dissipation structure 304 to the spacer structure 342. In some embodiments, the third portion 366 of the conductive material and the fourth portion 368 of the conductive material are formed on the third surface 318 of the first layer 304a of the second heat dissipation structure 304, and, once the third and fourth portions 366, 368 have been formed, the second heat dissipation structure 304, the third portion 366, and the fourth portion 368 are placed onto the spacer structure 342. The third portion 366 and the fourth portion 368 are then allowed to cure and harden coupling the second heat dissipation structure 304 to the spacer structure 342. The result of the fourth step 608 is readily visible in the second assembly 618 formed as shown in Figure 12D of the present disclosure.

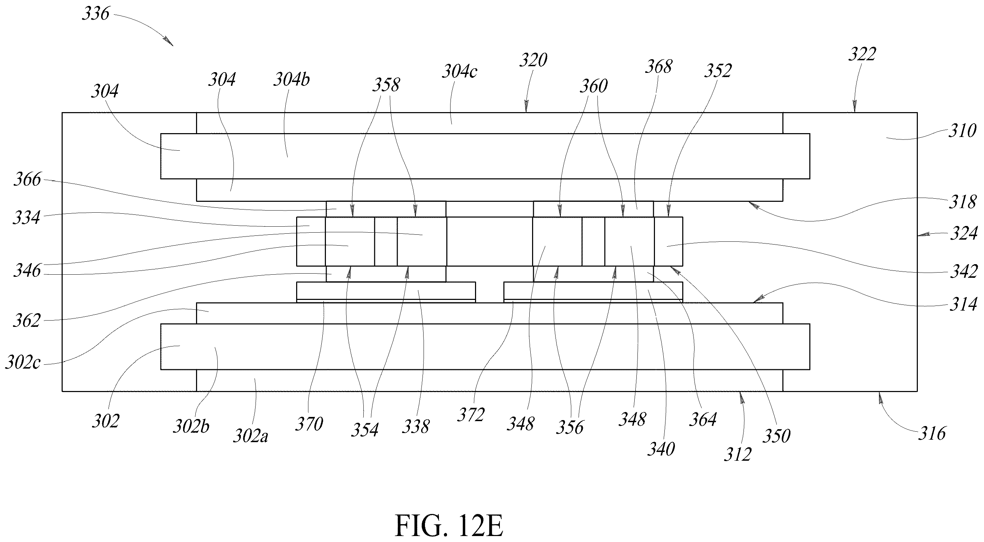

After the fourth step 608 in which the second assembly 618 has been formed by coupling the second heat dissipation structure 304 to the spacer structure 342 by forming the third portion 366 and the fourth portion 368, in a fifth step 610 the molding compound 310 is formed encasing the second assembly 618 within the molding compound 310. The molding compound 310 is formed with at least one of a molding compound injection technique, a molding compound compression technique, or some other suitable formation process for forming the molding compound 310 encasing the second assembly 618 within the molding compound 310. After the molding compound 310 has been formed in the fifth step 610, the semiconductor package 336 as shown in Figure 6B has been formed. It will be readily appreciated that Figure 12E is a reproduction of the semiconductor package 336 as shown in Figure 6B as a result of manufacturing the semiconductor package 336 with the method of manufacturing as set forth in the flowchart 600.

As discussed earlier herein, the embodiments of the semiconductor packages 213, 236, 242, 300, 336 are less expensive to manufacture relative to the semiconductor package 120 as shown in Figures 1C and 1D. In some embodiments, the semiconductor packages 213, 236, 242, 300, 336 are less expensive to manufacture as less copper molybdenum is required to manufacture the semiconductor packages 213, 236, 242, 300, 336 relative to the semiconductor package 120 while still maintaining an equivalent or greater robustness against CTE mismatch to prevent mechanical defects from propagating within the semiconductor packages 213, 236, 242, 300, 336 relative to the semiconductor package 120. Furthermore, in some embodiments, the semiconductor packages 213, 236, 242, 300, 336, the plurality of flange structures 210, 230, or the plurality of multi-flange structures 240 are made of an alloy less expensive than copper molybdenum such that the semiconductor packages 213, 236, 242, 300, 336 are less expensive to manufacture relative to the semiconductor package 120 while still maintaining an equivalent or greater robustness against CTE mismatch.

At least some embodiments of a device of the present disclosure include: a first heat dissipation structure including a first surface and a second surface opposite to the first surface; one or more die coupled to the second surface of the first heat dissipation structure; a second heat dissipation structure including a third surface and a fourth surface opposite to the third surface, the third surface faces towards the first heat dissipation structure; one or more first flange structures coupled to the third surface of the second heat dissipation structure, the one or more first flange structures extending from the third surface towards the one or more die; and a molding compound including a fifth surface and a sixth surface opposite to the fifth surface, the molding compound encases the first heat dissipation structure, the one or more die, the second heat dissipation structure, and the one or more first flange structures, and wherein: the first surface of the first heat dissipation structure is exposed at the fifth surface of the molding compound, and the fourth surface of the second heat dissipation structure is exposed from the sixth surface of the molding compound.

In some embodiments, the one or more first flange structures are one or more multi-flange structures, and each respective multi-flange structure includes: a first portion that is coupled to the third surface of the second heat dissipation structure; and a plurality of second portions that extend outward from the first portion and towards a corresponding die of the one or more die.

In some embodiments, there is a one-to-one relationship between the one or more multi-flange structures and the one or more die.

In some embodiments, the one or more first flange structures are separate and distinct flange structures, and each separate and distinct flange structure includes: a first portion coupled to the third surface of the second heat dissipation structure; and a second portion that extends outward from the first portion and towards a corresponding die of the one or more die.

In some embodiments, the first portion is wider than the second portion.

In some embodiments, for each respective die of the one or more die, there are at least two separate and distinct flange structures for each respective die.

In some embodiments, the device further includes one or more pillars offset outwardly from the plurality of die, and one or more pillars are between the second surface of the first heat dissipation structure and the third surface of the second heat dissipation structure.

In some embodiments, the one or more die include a first die and a second die on the second surface of the first heat dissipation structure; and the one or more pillars include at least one pillar that is between the first die and the second die.

In some embodiments, the device further includes one or more second flange structures offset outwardly from the one or more first flange structures, and each respective second flange structure of the one or more second flange structures includes: a first portion that is coupled to the second surface of the first heat dissipation structure; and a second portion that extends outwardly from the first portion and towards the third surface of the second heat dissipation structure.

In some embodiments, each respective first flange structure of the one or more first flange structures includes: a first portion that is coupled to the third surface of the second heat dissipation structure; and a second portion that extends outwardly from the first portion and towards the third surface of the second heat dissipation structure; the first portions of the one or more first flange structures are welded to the third surface of the second heat dissipation structure; and the first portions of the one or more second flange structures are welded to the second surface of the first heat dissipation structure.

In some embodiments, the one or more first flange structures are welded to the third surface of the second heat dissipation structure.

At least some embodiments of a device of the present disclosure include: a first heat dissipation structure including a first surface and a second surface opposite to the first surface; one or more die coupled to the second surface of the first heat dissipation structure; a spacer structure on the one or more die, the spacer structure including: an insulating material including a first surface and a second surface opposite to the first surface; and one or more conductive vias in the insulating material, the one or more conductive vias extend through the insulating material, the one or more conductive vias include first ends exposed at the first surface and second ends exposed at the second surface, the one or more conductive vias overlap the one or more die; one or more first conductive portions extending from the first ends of the one or more conductive vias to the one or more die; a second heat dissipation structure overlapping the spacer structure, the one or more die, and the first heat dissipation structure, the second heat dissipation structure including a third surface and a fourth surface opposite to the third surface; one or more second conductive portions extending from the second ends of the one or more conductive vias to the third surface of the second heat dissipation structure; and a molding compound including a fifth surface and a sixth surface opposite to the fifth surface, the molding compound encases the first heat dissipation structure, the one or more die, the second heat dissipation structure, and the spacer structure, and wherein: the first surface of the first heat dissipation structure is exposed at the fifth surface of the molding compound, and the fourth surface of the second heat dissipation structure is exposed from the sixth surface of the molding compound.

In some embodiments, there is at least a two-to-one relationship between the one or more conductive vias of the spacer structure and the one or more die.

In some embodiments, the first ends of the one or more conductive vias extend outward from the first surface of the insulating material and the second ends of the one or more conductive vias extend outward from the second surface of the insulating material.

In some embodiments, the one or more conductive vias are tapered.

In some embodiments, the insulating material includes at least one of an n-polygon profile. At least one embodiments of a method of the present disclosure include: forming a first assembly including: coupling one or more die to a second surface of a first heat dissipation structure opposite to a first surface of the heat dissipation structure; forming a second assembly including: coupling first portions of one or more first flange structures to a third surface of a second heat dissipation structure opposite to a fourth surface of the second heat dissipation structure; coupling the first assembly to the second assembly including: coupling respective ends of second portions of the one or more first flange structures that extend outwardly from the first portions of the one or more first flange structures to one or more contacts of the one or more die on the second surface of the first heat dissipation structure.

In some embodiments, forming the first assembly further includes: coupling one or more pillars to the second surface of the first heat dissipation structure at regions offset from the one or more die; forming the second assembly further includes: forming one or more conductive regions on the third surface of the second heat dissipation structure offset from the one or more first flange structures; coupling the first assembly to the second assembly further includes: coupling the plurality pillars to the one or more conductive regions.

In some embodiments, coupling the first portions of the one or more first flange structures to the third surface of the second heat dissipation structure further includes ultrasonically welding first ends of the one or more first flange structures to the third surface of the second heat dissipation structure.

In some embodiments, forming the first assembly further includes: coupling first portions of one or more second flange structures to the second surface of the first heat dissipation structure at regions offset from the one or more die, and the second flange structures including respective ends extending outwardly from the first portions of the one or more second flange structures.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A device (213, 236, 242), comprising:
a first heat dissipation structure (102) including a first surface (112) and a second surface (114) opposite to the first surface;
one or more die (204) coupled to the second surface (114) of the first heat dissipation structure (102);
a second heat dissipation structure (104) including a third surface (116) and a fourth surface (118) opposite to the third surface, the third surface (116) facing towards the first heat dissipation structure (102);
one or more first flange structures (210, 240) coupled to the third surface (116) of the second heat dissipation structure (104), the one or more first flange structures (210, 240) extending from the third surface (116) towards the one or more die (204); and
a molding compound (215) including a fifth surface (216) and a sixth surface (218) opposite to the fifth surface, the molding compound (215) encasing the first heat dissipation structure (102), the one or more die (204), the second heat dissipation structure (104), and the one or more first flange structures (210, 240), and wherein:
the first surface (112) of the first heat dissipation structure (102) is exposed at the fifth surface (216) of the molding compound (215), and the fourth surface (118) of the second heat dissipation structure (104) is exposed at the sixth surface (218) of the molding compound (215);
wherein preferably the one or more first flange structures (210, 240) are welded to the third surface (116) of the second heat dissipation structure (104).

2. The device (242) of claim 1, wherein the one or more first flange structures (210, 240) are one or more multi-flange structures (240), and each respective multi-flange structure (240) includes:
a first portion (240a) that is coupled to the third surface (116) of the second heat dissipation structure (104); and
a plurality of second portions (240b) that extend outward from the first portion (240a) and towards a corresponding die (204) of the one or more die;
and wherein preferably there is a one-to-one relationship between the one or more multi-flange structures (240) and the one or more die (204).

3. The device (213, 236) of claim 1, wherein the one or more first flange structures (210, 240) are separate and distinct flange structures (210), and each separate and distinct flange structure (210) includes:
a first portion (210a) coupled to the third surface (116) of the second heat dissipation structure (104); and
a second portion (210b) that extends outward from the first portion (210a) and towards a corresponding die (204) of the one or more die;
and wherein preferably the first portion (210a) is wider than the second portion (210b);
and wherein preferably, for each respective die (204) of the one or more die (204), there are at least two separate and distinct flange structures (210) for each respective die (204).

4. The device (213, 242) of any of the previous claims, further comprising one or more pillars (202) offset outwardly from the plurality of die (204), wherein the one or more pillars (202) are between the second surface (114) of the first heat dissipation structure (102) and the third surface (116) of the second heat dissipation structure (104).

5. The device (213, 242) of claim 4, wherein:
the one or more die (204) include a first die (204a) and a second die (204b) on the second surface (114) of the first heat dissipation structure (102); and
the one or more pillars (202) include at least one pillar that is between the first die (204a) and the second die (204b).

6. The device (236) of any of claims 1 to 3, further comprising one or more second flange structures (230) offset outwardly from the one or more first flange structures (210, 240), and wherein each respective second flange structure (230) of the one or more second flange structures (230) includes:
a first portion that is coupled to the second surface (114) of the first heat dissipation structure (102); and
a second portion that extends outwardly from the first portion and towards the third surface (116) of the second heat dissipation structure (104).

7. The device (236) of claim 6, wherein:
each respective first flange structure (210, 240) of the one or more first flange structures (210, 240) includes:
a first portion (210a, 240a) that is coupled to the third surface (116) of the second heat dissipation structure (104); and
a second portion (210b, 240b) that extends outwardly from the first portion (210a, 240a) and towards the second surface (114) of the first heat dissipation structure (102);
the first portions (210a, 240a) of the one or more first flange structures (210, 240) are welded to the third surface (116) of the second heat dissipation structure (104); and
the first portions of the one or more second flange structures (230) are welded to the second surface (114) of the first heat dissipation structure (102).

8. A device (300, 336), comprising:
a first heat dissipation structure (302) including a first surface (312) and a second surface (314) opposite to the first surface;
one or more die (306) coupled to the second surface (314) of the first heat dissipation structure (302);
a spacer structure (308, 342, 400, 414, 424) on the one or more die (306), the spacer structure (308, 342, 400, 414, 424) including:
an insulating material (328, 344, 402) including a first surface (329, 350, 406) and a second surface (335, 352, 408) opposite to the first surface; and
one or more conductive vias (330, 346, 348, 404, 416, 426) in the insulating material (328, 344, 402), the one or more conductive vias (330, 346, 348, 404, 416, 426) extending through the insulating material (328, 344, 402), the one or more conductive vias (330, 346, 348, 404, 416, 426) including first ends (331, 354, 356, 410) exposed at the first surface (329, 350, 406) of the insulating material (328, 344, 402) and second ends (333, 358, 360, 412) exposed at the second surface (335, 352, 408) of the insulating material (328, 344, 402), the one or more conductive vias (330, 346, 348, 404, 416, 426) overlapping the one or more die (306);
one or more first conductive portions (332, 362, 364) extending from the first ends (331, 354, 356, 410) of the one or more conductive vias (330, 346, 348, 404, 416, 426) to the one or more die (306);
a second heat dissipation structure (304) overlapping the spacer structure (308, 342, 400, 414, 424), the one or more die (306), and the first heat dissipation structure (302), the second heat dissipation structure (304) including a third surface (318) and a fourth surface (320) opposite to the third surface;
one or more second conductive portions (334, 366, 368) extending from the second ends (333, 358, 360, 412) of the one or more conductive vias (330, 346, 348, 404, 416, 426) to the third surface (318) of the second heat dissipation structure (304); and
a molding compound (310) including a fifth surface (316) and a sixth surface (322) opposite to the fifth surface, the molding compound (310) encasing the first heat dissipation structure (302), the one or more die (306), the second heat dissipation structure (304), and the spacer structure (308, 342, 400, 414, 424), and wherein:
the first surface (312) of the first heat dissipation structure (302) is exposed at the fifth surface (316) of the molding compound (310), and the fourth surface (320) of the second heat dissipation structure (304) is exposed from the sixth surface (322) of the molding compound (310).

9. The device (300, 336) of claim 8, wherein there is at least a two-to-one relationship between the one or more conductive vias (330, 346, 348, 404, 416, 426) of the spacer structure (308, 342, 400, 414, 424) and the one or more die (306).

10. The device (300, 336) of claim 8 or claim 9, wherein the first ends (410) of the one or more conductive vias (404, 416) extend outward from the first surface (406) of the insulating material (402) and the second ends (412) of the one or more conductive vias (404, 416) extend outward from the second surface (408) of the insulating material (402).

11. The device (300, 336) of any of claims 8 to 10, wherein the one or more conductive vias (416) are tapered, and wherein preferably the insulating material (402) includes at least one of an n-polygon profile.

12. A method (500), comprising:
forming (502) a first assembly (210) including:
coupling one or more die (204) to a second surface (114) of a first heat dissipation structure (102) opposite to a first surface (112) of the first heat dissipation structure (102);
forming (504) a second assembly (208) including:
coupling first portions (210a) of one or more first flange structures (210) to a third surface (116) of a second heat dissipation structure (104) opposite to a fourth surface (118) of the second heat dissipation structure (104);
coupling (506) the first assembly (210) to the second assembly (208) including:
coupling respective ends of second portions (210b) of the one or more first flange structures (210) that extend outwardly from the first portions (210a) of the one or more first flange structures (210) to one or more contacts (206) of the one or more die (204) on the second surface (114) of the first heat dissipation structure (102).

13. The method (500) of claim 12, wherein:
forming (502) the first assembly (210) further includes:
coupling one or more pillars (202) to the second surface (114) of the first heat dissipation structure (102) at regions offset from the one or more die (204);
forming (504) the second assembly (208) further includes:
forming one or more conductive regions (214) on the third surface (116) of the second heat dissipation structure (104) offset from the one or more first flange structures (210);
coupling the first assembly (210) to the second assembly (208) further includes:
coupling the plurality of pillars (202) to the one or more conductive regions (214).

14. The method of claim 12, wherein coupling the first portions (210a) of the one or more first flange structures (210) to the third surface (116) of the second heat dissipation structure (104) further includes ultrasonically welding first ends of the one or more first flange structures (210) to the third surface (116) of the second heat dissipation structure (104).

15. The method of claim 12, wherein:
forming (502) the first assembly (210) further includes:
coupling first portions of one or more second flange structures (230) to the second surface (114) of the first heat dissipation structure (102) at regions offset from the one or more die (204), and the second flange structures (230) including respective ends extending outwardly from the first portions of the one or more second flange structures.
